(19) **Europäisches Patentamt / European Patent Office / Office européen des brevets**

(11) **EP 4 779 908 A1**

(12) **EUROPEAN PATENT APPLICATION**
published in accordance with Art. 153(4) EPC

(43) Date of publication:
**22.07.2026 Bulletin 2026/30**

(21) Application number: **23952609.8**

(22) Date of filing: **20.09.2023**

(51) International Patent Classification (IPC):
**H04L 1/00** $^{(2006.01)}$

(52) Cooperative Patent Classification (CPC):
**H04L 1/00**

(86) International application number:
**PCT/CN2023/120201**

(87) International publication number:
**WO 2025/059949 (27.03.2025 Gazette 2025/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **HUAWEI TECHNOLOGIES CO., LTD.
Shenzhen 518129 (CN)**

(72) Inventors:
• **WANG, Xianbin**
 **Shenzhen, Guangdong 518129 (CN)**
• **TONG, Jiajie**
 **Shenzhen, Guangdong 518129 (CN)**

• **ZHANG, Huazi**
 **Shenzhen, Guangdong 518129 (CN)**
• **QIN, Kangjian**
 **Shenzhen, Guangdong 518129 (CN)**
• **LIU, Ke**
 **Shenzhen, Guangdong 518129 (CN)**
• **WANG, Jun**
 **Shenzhen, Guangdong 518129 (CN)**
• **TONG, Wen**
 **Shenzhen, Guangdong 518129 (CN)**
• **DU, Yinggang**
 **Shenzhen, Guangdong 518129 (CN)**

(74) Representative: **Goddar, Heinz J.**
 **Boehmert & Boehmert
 Anwaltspartnerschaft mbB
 Pettenkoferstrasse 22
 80336 München (DE)**

(54) **COMMUNICATION METHOD AND APPARATUS**

(57) A communication method and apparatus are provided and related to the field of communication technologies, which can map some information bits to all sent sequences, to improve decoding performance. In the method, K first bit positions are determined based on a reliability sequence having a length of $N_1$, and K second bit positions are determined based on a reliability sequence having a length of $N_2$; bit positions of a first sequence having a length of $(N_2-N_1)$ are divided into X groups of bit positions, and A first bit positions are divided into X groups of first bit positions, where the X groups of bit positions include A second bit positions, a quantity of first bit positions included in an $x^{th}$ group of first bit positions is the same as a quantity of second bit positions included in an $x^{th}$ group of bit positions, and x=1, 2, ..., X; and information bits corresponding to the $x^{th}$ group of first bit positions are mapped based on an information bit sequence having a length of K to the second bit positions in the $x^{th}$ group of bit positions of the first sequence, to obtain a second sequence, polar coding is performed to obtain an encoded bit sequence, and one or more bits in the encoded bit sequence are sent to a receiver device.

EP 4 779 908 A1

```
┌─────────────────┐                    ┌─────────────────┐
│   Transmitter   │                    │    Receiver     │
│     device      │                    │     device      │
└─────────────────┘                    └─────────────────┘
```

801: Determine K first bit positions based on a reliability sequence having a length of $N_1$

802: Determine K second bit positions based on a reliability sequence having a length of $N_2$

803: Divide bit positions of a first sequence having a length of $(N_2-N_1)$ into X groups of bit positions

804: Divide A first bit positions in the K first bit positions into X groups of first bit positions

805: Map, based on an information bit sequence having a length of K, information bits corresponding to the $x^{th}$ group of first bit positions to the second bit positions in the $x^{th}$ group of bit positions of the first sequence, to obtain a second sequence

806: The transmitter device performs polar coding on the second sequence to obtain an encoded bit sequence

807: Send one or more bits in the encoded bit sequence

807: Receive a symbol sequence

808: Determine K first bit positions based on a reliability sequence having a length of $N_1$, and determine K second bit positions based on a reliability sequence having a length of $N_2$

809: Divide bit positions of a first sequence having a length of $(N_2-N_1)$ into X groups of bit positions, and divide A first bit positions in the K first bit positions into X groups of first bit positions

810: Decode the symbol sequence based on the X groups of first bit positions and second bit positions in the X groups of bit positions

FIG. 8

**Description**

**TECHNICAL FIELD**

Embodiments of this application relate to the field of communication technologies, and in particular, to a communication method and apparatus.

**BACKGROUND**

In communication systems, to reduce coding complexity, it is proposed to adopt an encoding scheme using polar codes (Polar codes). Before encoding is performed by using polar codes, information bits of a to-be-encoded sequence need to be mapped to corresponding bit positions.

When polar codes used for hybrid automatic repeat request (hybrid automatic repeat request, HARQ) transmission are constructed, some information bits of to-be-encoded sequences may be mapped to both an initial transmission sequence and a retransmission sequence. In this way, good decoding performance can be obtained regardless of whether the initial transmission sequence is decoded alone or the initial transmission sequence and the retransmission sequence are jointly decoded. Alternatively, when polar codes supporting self-decoding are constructed, some information bits of to-be-encoded sequences may be mapped to a plurality of redundancy versions. In this way, when independent decoding is performed based on each redundancy version, good decoding performance can be obtained.

Based on the foregoing description about the polar codes used for HARQ transmission and the polar codes supporting self-decoding, encoding and decoding thereof are both predicated on mapping some information bits across various transmitted sequences. Therefore, how to map information bits to reduce decoding complexity and improve decoding performance becomes a technical problem to be urgently resolved.

**SUMMARY**

Embodiments of this application provide a communication method and apparatus, which can map some information bits to all sent sequences, to reduce decoding complexity and improving decoding performance.

According to a first aspect, an embodiment of this application provides a communication method. The method may be performed by a transmitter device, or may be performed by a component (for example, a processor, a chip, or a chip system) of the transmitter device, or may be implemented by a logical module or software that can implement all or some functions of the transmitter device. The method includes: determining K first bit positions based on a reliability sequence having a length of $N_1$, and determining K second bit positions based on a reliability sequence having a length of $N_2$, where $K \leq N_1 < N_2$; dividing bit positions of a first sequence having a length of $(N_2-N_1)$ into X groups of bit positions, and dividing A first bit positions in the K first bit positions into X groups of first bit positions, where the X groups of bit positions include A second bit positions in the K second bit positions, a quantity of first bit positions included in an $x^{th}$ group of first bit positions is the same as a quantity of second bit positions included in an $x^{th}$ group of bit positions, $X \geq 2$, and x=1, 2, ..., X; mapping, based on an information bit sequence having a length of K, information bits corresponding to the $x^{th}$ group of first bit positions to the second bit positions in the $x^{th}$ group of bit positions of the first sequence, to obtain a second sequence; performing polar coding on the second sequence to obtain an encoded bit sequence; and sending one or more bits in the encoded bit sequence to a receiver device.

Based on the first aspect, some information bits (for example, A information bits) in the information bit sequence having a length of K may be mapped to both the A first bit positions and the A second bit positions. In other words, there is a corresponding check relationship between the A first bit positions and the A second bit positions, so that decoding complexity can be reduced, and decoding performance can be improved. In addition, during bit mapping in this application, hierarchical mapping may be further performed. To be specific, A first bit positions are divided into X groups of first bit positions, and bit positions of a first sequence are divided into X groups of bit positions. In this way, a transmitter device may map information bits corresponding to an $x^{th}$ group of first bit positions to second bit positions in an $x^{th}$ group of bit positions of the first sequence, to implement hierarchical mapping. In addition, there is a corresponding check relationship between the $x^{th}$ group of first bit positions and the second bit positions in the $x^{th}$ group of bit positions. Therefore, decoding complexity can be reduced, performance of a small quantity of retransmission and a large quantity of retransmission can be balanced, and decoding performance can be improved.

In a possible design, the information bits corresponding to the $x^{th}$ group of first bit positions are mapped in an interleaving manner based on a first interleaving pattern, to the second bit positions in the $x^{th}$ group of bit positions.

Based on this possible design, interleaved mapping processing may be performed on the information bits based on the first interleaving pattern, to reduce decoding complexity and improve decoding performance.

In a possible design, information bits corresponding to first bit positions sorted in ascending order of numbers in the $x^{th}$ group of first bit positions are mapped in an interleaving manner based on the first interleaving pattern, to second bit positions sorted in descending order of numbers in the $x^{th}$ group of bit positions.

Based on this possible design, the information bits corresponding to the $x^{th}$ group of first bit positions may be mapped in an interleaving manner to the $x^{th}$ group of second bit positions by using a reverse-order mapping relationship, so that the transmitter device only needs to sequentially push data and does not need to pre-store a specific mapping relationship. This can greatly simplify implementation and reduce implementation complexity.

In a possible design, the information bit sequence is mapped to the K first bit positions of a third sequence having a length of $N_1$, to obtain a fourth sequence; and information bits corresponding to the $x^{th}$ group of first bit positions are determined based on information bits corresponding to the A first bit positions in the K first bit positions.

Based on this possible design, a feasible solution is provided for determining the information bits corresponding to the A first bit positions.

In a possible design, exclusive OR processing is performed on the second sequence and the fourth sequence, to obtain an XOR-processed sequence, and polar coding is performed on the XOR-processed sequence, to obtain an encoded bit sequence.

In a possible design, polar coding is performed on the second sequence to obtain a first polarization sequence; polar coding is performed on the fourth sequence to obtain a second polarization sequence; and exclusive OR processing is performed on the first polarization sequence and the second polarization sequence to obtain an encoded bit sequence.

Based on the foregoing two possible designs, a plurality of feasible solutions are provided for performing polar coding on the second sequence.

According to a second aspect, an embodiment of this application provides a communication method. The method may be performed by a receiver device, or may be performed by a component (for example, a processor, a chip, or a chip system) of the receiver device, or may be implemented by a logical module or software that can implement all or some functions of the receiver device. The method includes: receiving a symbol sequence from a transmitter device, where an information bit sequence corresponding to the symbol sequence has a length of K; determining K first bit positions based on a reliability sequence having a length of $N_1$, and determining K second bit positions based on a reliability sequence having a length of $N_2$, where $K \leq N_1 < N_2$; dividing bit positions of a first sequence having a length of $(N_2-N_1)$ into X groups of bit positions, and dividing A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; and decoding the symbol sequence based on second bit positions in the X groups of bit positions and the X groups of first bit positions.

Based on the second aspect, when encoding the information bit sequence, the transmitter device maps some information bits (for example, the A information bits) of the information bit sequence having a length of K to both the X groups of first bit positions and the second bit positions in the X groups of bit positions. In other words, there is a corresponding check relationship between the X groups of first bit positions and the second bit positions in the X groups of bit positions. When decoding the symbol sequence, the receiver device may determine the X groups of first bit positions and the second bit positions in the X groups of bit positions in a manner the same as that of the transmitter device, so as to implement decoding based on the check relationship between the X groups of first bit positions and the second bit positions in the X groups of bit positions, thereby reducing decoding complexity and improving decoding performance.

According to a third aspect, an embodiment of this application provides a communication method. The method may be performed by a transmitter device, or may be performed by a component (for example, a processor, a chip, or a chip system) of the transmitter device, or may be implemented by a logical module or software that can implement all or some functions of the transmitter device. The method includes: determining K first bit positions based on a reliability sequence having a length of $N_1$, and determining K second bit positions based on a reliability sequence having a length of $N_2$, where $K \leq N_1 < N_2$; dividing bit positions of a first sequence having a length of $(N_2-N_1)$ into X groups of bit positions, and dividing A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; and mapping, based on an information bit sequence having a length of K, information bits corresponding to the $x^{th}$ group of first bit positions to an $x^{th}$ group of third bit positions in a fifth sequence having a length of $N_2$, mapping copy bits of the information bits corresponding to the $x^{th}$ group of first bit positions to the second bit positions in the $x^{th}$ group of bit positions in the fifth sequence, to obtain a sixth sequence, performing polar coding on the sixth sequence to obtain an encoded bit sequence, and sending one or more bits in the encoded bit sequence to a receiver device, where the $x^{th}$ group of third bit positions corresponds to the $x^{th}$ group of first bit positions.

Based on the third aspect, some information bits (for example, the A information bits) of the information bit sequence having a length of K may be mapped to both the A second bit positions and the A third bit positions. In other words, there is a corresponding check relationship between the A second bit positions of the sixth sequence and the A third bit positions. This can reduce decoding complexity and improve decoding performance. In addition, during bit mapping in this application, hierarchical mapping may be further performed. To be specific, A first bit positions may be divided into X groups of first bit positions, bit positions of a first sequence may be divided into X groups of bit positions, and A third bit positions may be divided into X groups of third bit positions. In this way, the transmitter device may map the information bits corresponding to the $x^{th}$ group of first bit positions to the $x^{th}$ group of third bit positions of a fifth sequence, and map copy bits of the information bits corresponding to the $x^{th}$ group of first bit positions to the second bit positions in the $x^{th}$ group of bit positions of the fifth sequence, to implement hierarchical mapping. In addition, there is a corresponding check relationship between the $x^{th}$ group of third bit positions and the second bit positions in the $x^{th}$ group of bit positions, so that decoding complexity can be reduced, and decoding performance can be improved.

In a possible design, the information bits corresponding to the $x^{th}$ group of first bit positions are mapped in an interleaving manner based on a second interleaving pattern, to the $x^{th}$ group of third bit positions in the fifth sequence, and the copy bits of the information bits corresponding to the $x^{th}$ group of first bit positions are mapped in an interleaving manner to the second bit positions in the $x^{th}$ group of bit positions in the fifth sequence.

Based on this possible design, interleaved mapping processing may be performed on the information bits based on the second interleaving pattern, to reduce decoding complexity and improve decoding performance.

In a possible design, the information bit sequence is mapped to the K first bit positions of a third sequence having a length of $N_1$, to obtain a fourth sequence; and information bits corresponding to the $x^{th}$ group of first bit positions are determined based on information bits corresponding to the A first bit positions in the K first bit positions.

Based on this possible design, a feasible solution is provided for determining the information bits corresponding to the A first bit positions.

In a possible design, K-A information bits other than A information bits corresponding to the X groups of first bit positions in the information bit sequence are mapped to K-A second bit positions other than the A second bit positions in the K second bit positions of the fifth sequence.

According to a fourth aspect, an embodiment of this application provides a communication method. The method may be performed by a receiver device, or may be performed by a component (for example, a processor, a chip, or a chip system) of the receiver device, or may be implemented by a logical module or software that can implement all or some functions of the receiver device. The method includes: receiving a symbol sequence from a transmitter device, where an information bit sequence corresponding to the symbol sequence has a length of K; determining K first bit positions based on a reliability sequence having a length of $N_1$, and determining K second bit positions based on a reliability sequence having a length of $N_2$, where $K \leq N_1 < N_2$; dividing bit positions of a first sequence having a length of $(N_2-N_1)$ into X groups of bit positions, and dividing A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and $x=1, 2, ..., X$; and decoding the symbol sequence based on second bit positions in the X groups of bit positions and X groups of third bit positions, where an $x^{th}$ group of third bit positions corresponds to the $x^{th}$ group of first bit positions, $X \geq 2$, and $x=1, 2, ..., X$.

Based on the fourth aspect, when encoding the information bit sequence, the transmitter device copies A information bits in the information bit sequence, and maps the A information bits and A copy bits to the X groups of third bit positions and the second bit positions in the X groups of bit positions. In other words, there is a corresponding check relationship between the X groups of third bit positions and the second bit positions in the X groups of bit positions. When decoding the symbol sequence, the receiver device may determine the second bit positions in the X groups of bit positions and the X groups of third bit positions in a manner the same as that of the transmitter device, so as to implement decoding based on the check relationship between the X groups of third bit positions and the second bit positions in the X groups of bit positions, thereby reducing decoding complexity and improving decoding performance.

Based on the first aspect to the fourth aspect, in a possible design, the A first bit positions are determined based on the K first bit positions and the K second bit positions.

Based on the first aspect to the fourth aspect, in a possible design, K third bit positions are determined based on the K first bit positions, where a number of a third bit position corresponding to a first bit position numbered i is $i+N_2-N_1$, and $0 \leq i \leq N_1-1$; the A first bit positions are determined based on A third bit positions, where a number of a first bit position corresponding to a third bit position numbered j is $j-(N_2-N_1)$, and $N_2-N_1 \leq j \leq N_2-1$; and the A third bit positions are bit positions that are in the K third bit positions and whose numbers are different from those of the K second bit positions.

Based on the first aspect to the fourth aspect, in a possible design, the A first bit positions are the last A bit positions sorted in descending order of reliability in the K first bit positions.

Based on the foregoing three possible designs, a plurality of feasible solutions are provided for determining the A first bit positions.

Based on the first aspect to the fourth aspect, in a possible design, the A second bit positions are determined based on the K first bit positions and the K second bit positions.

Based on the first aspect to the fourth aspect, in a possible design, K third bit positions are determined based on the K first bit positions, where a number of a third bit position corresponding to a first bit position numbered i is $i+N_2-N_1$, and $0 \leq i \leq N_1-1$; and the A second bit positions are determined based on the K third bit positions, where the A second bit positions are bit positions that are in the K second bit positions and whose numbers are different from those of the K third bit positions.

Based on the first aspect to the fourth aspect, in a possible design, the A second bit positions are A bit positions whose numbers are less than $N_2-N_1$ in the K second bit positions.

Based on the foregoing three possible designs, a plurality of feasible solutions are provided for determining the A second bit positions.

Based on the first aspect to the fourth aspect, in a possible design, the A first bit positions are divided into the X groups of first bit positions based on reliability, where reliability of an $(x+1)^{th}$ group of first bit positions is higher than reliability of the $x^{th}$ group of first bit positions.

Based on this possible design, a feasible solution is provided for grouping the first bit positions.

Based on the first aspect to the fourth aspect, in a possible design, sub-block interleaving is performed on the first sequence based on a third interleaving pattern, and bit positions of an interleaved first sequence are divided into the X groups of bit positions, where the $x^{th}$ group of bit positions includes Yx sub-blocks, and Yx is a positive integer.

Based on this possible design, the transmitter device may divide the first sequence into the X groups of bit positions, or may divide, after performing interleaving (for example, sub-block interleaving) on the first sequence, the bit positions of the interleaved first sequence into the X groups of bit positions, to reduce decoding complexity and improve decoding performance.

Based on the first aspect to the fourth aspect, in a possible design, the third interleaving pattern is any one of the following sub-block interleaving patterns: [0 1 2 4 3 5 6 7 8 16 9 17 10 18 11 19 12 20 13 21 14 22 15 23 24 25 26 28 27 29 30 31], or [0 4 8 12 1 5 9 13 2 6 10 14 3 7 11 15 16 20 24 28 17 21 25 29 18 22 26 30 19 23 27 31], or [0 8 16 24 1 9 17 25 2 10 18 26 3 11 19 27 4 12 20 28 5 13 21 29 6 14 22 30 7 15 23 31].

Based on this possible design, a plurality of possible designs are provided for the third interleaving pattern.

Based on the first aspect to the fourth aspect, in a possible design, the bit positions of the first sequence are divided into the X groups of bit positions based on preset configuration information; or the bit positions of the first sequence are divided into the X groups of bit positions based on a retransmission resource.

Based on this possible design, the transmitter device may perform grouping based on the preset configuration information, or may perform grouping based on the retransmission resource, to balance performance of a small quantity of retransmission and a large quantity of retransmission, and reduce decoding complexity.

Based on the first aspect to the fourth aspect, in a possible design, a length of at least one group of bit positions in the X groups of bit positions is an integer power of 2.

Based on the first aspect to the fourth aspect, in a possible design, a length of a first group of bit positions in the X groups of bit positions is an integer power of 2.

Based on the first aspect to the fourth aspect, in a possible design, a length from the first group of bit positions to an $x'^{th}$ group of bit positions in the X groups of bit positions is an integer power of 2, where $2 \le x' \le X$.

Based on the foregoing three possible designs, when the transmitter device divides the first sequence into the X groups of bit positions, it can be ensured that a length of at least one group of bit positions meets an integer power of 2, thereby reducing decoding complexity and improving decoding performance.

Based on the first aspect to the fourth aspect, in a possible design, X is equal to 2, the first group of bit positions in the X groups of bit positions includes $(N_2-N_1)/8$ bit positions of the first sequence, and a second group of bit positions includes $7(N_2-N_1)/8$ bit positions of the first sequence.

Based on this possible design, the last $(N_2-N_1)/8$ bit positions may be divided into one group, and the remaining $7(N_2-N_1)/8$ bits may be divided into one group, to minimize a chip area.

Based on the first aspect to the fourth aspect, in a possible design, X is equal to 3, the first group of bit positions in the X groups of bit positions includes $(N_2-N_1)/8$ bit positions of the first sequence, a second group of bit positions includes $(N_2-N_1)/8$ bit positions of the first sequence, and a third group of bit positions includes $3(N_2-N_1)/4$ bit positions of the first sequence.

Based on this possible design, the last $(N_2-N_1)/8$ bit positions may be divided into one group, then the $(N_2-N_1)/8$ bit positions are divided into one group, and the remaining $3(N_2-N_1)/4$ bit positions are divided into one group. Compared with the foregoing possible design, although the chip area may be increased, decoding performance can be further improved.

Based on the first aspect to the fourth aspect, in a possible design, X is equal to 4, the first group of bit positions in the X groups of bit positions includes $(N_2-N_1)/8$ bit positions of the first sequence, a second group of bit positions includes $(N_2-N_1)/8$ bit positions of the first sequence, a third group of bit positions includes $(N_2-N_1)/4$ bit positions of the first sequence, and a fourth group of bit positions includes $(N_2-N_1)/2$ bit positions of the first sequence.

Based on this possible design, the last $(N_2-N_1)/8$ bit positions may be divided into one group, then the $(N_2-N_1)/8$ bit positions are divided into one group, then the $(N_2-N_1)/4$ bit positions are divided into one group, and the remaining $(N_2-N_1)/2$ bit positions are divided into one group. Compared with the first two possible designs, a balance between the chip area and the decoding performance can be achieved.

Based on the first aspect to the fourth aspect, in a possible design, X is equal to 2, the first group of bit positions in the X groups of bit positions includes $(N_2-N_1)/4$ bit positions of the first sequence, and a second group of bit positions

includes $3(N_2-N_1)/4$ bit positions of the first sequence.

Based on this possible design, the last $(N_2-N_1)/4$ bit positions may be divided into one group, and the remaining $3(N_2-N_1)/4$ bit positions may be divided into one group. Compared with the first three possible designs, on the basis that the balance between the chip area and the decoding performance is achieved, better performance can be preferentially ensured during retransmission of $(N_2-N_1)/4$ bit positions.

According to a fifth aspect, an embodiment of this application provides a communication method. The method may be performed by a transmitter device, or may be performed by a component (for example, a processor, a chip, or a chip system) of the transmitter device, or may be implemented by a logical module or software that can implement all or some functions of the transmitter device. The method includes: dividing bit positions of a seventh sequence having a length of N into X groups of bit positions, and dividing A information bits in an information bit sequence having a length of K into X groups of information bits, where a quantity of information bit positions included in an $x^{th}$ group of bit positions is equal to a quantity of information bits included in an $x^{th}$ group of information bits, x=1, 2, ..., X, and X≥2; mapping, in an interleaving manner based on an interleaving pattern, the $x^{th}$ group of information bits to the information bit positions in the $x^{th}$ group of bit positions of the seventh sequence, to obtain an eighth sequence; and performing polar coding on the eighth sequence to obtain an encoded bit sequence, and sending one or more bits in the encoded bit sequence to a receiver device.

Based on the fifth aspect, when encoding the information bit sequence, the transmitter device may perform grouping processing on the information bit sequence, and then perform interleaving processing based on the interleaving pattern, to reduce decoding complexity and improve decoding performance.

According to a sixth aspect, an embodiment of this application provides a communication method. The method may be performed by a receiver device, or may be performed by a component (for example, a processor, a chip, or a chip system) of the receiver device, or may be implemented by a logical module or software that can implement all or some functions of the receiver device. The method includes: receiving a symbol sequence from a transmitter device; dividing bit positions of a seventh sequence having a length of N into X groups of bit positions, where X≥2; and decoding the symbol sequence based on information bit positions in the X groups of bit positions.

Based on the sixth aspect, when encoding the information bit sequence, the transmitter device groups the A information bits in the information bit sequence, and maps the A information bits to the information bit positions in the X groups of bit positions in an interleaving manner based on the interleaving pattern. When decoding the symbol sequence, the receiver device may determine the information bit positions in the X groups of bit positions in a manner the same as that of the transmitter device, to decode the symbol sequence based on the interleaving pattern and the information bit positions in the X groups of bit positions, thereby reducing decoding complexity and improving decoding performance.

In a possible design, sub-block interleaving is performed on the seventh sequence, and bit positions of an interleaved seventh sequence are divided into the X groups of bit positions.

In a possible design, the interleaving pattern is one or more of the following: a random interleaving pattern, a triangular interleaving pattern, a row-column interleaving pattern, or a reverse-order interleaving pattern.

According to a seventh aspect, an embodiment of this application provides a communication apparatus. The communication apparatus may be applied to the transmitter device in the first aspect, the third aspect, or the fifth aspect, to implement a function performed by the transmitter device. The communication apparatus may be a transmitter device, or may be a chip, a chip system, a system on chip, or the like of the transmitter device. The communication apparatus may perform the function performed by the transmitter device by hardware, or may perform the function by hardware executing corresponding software. The hardware or the software includes one or more modules corresponding to the foregoing function, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

For example, the processing module is configured to: determine K first bit positions based on a reliability sequence having a length of $N_1$, and determine K second bit positions based on a reliability sequence having a length of $N_2$, where $K≤N_1<N_2$; the processing module is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, a quantity of first bit positions included in an $x^{th}$ group of first bit positions is the same as a quantity of second bit positions included in an $x^{th}$ group of bit positions, X≥2, and x=1, 2, ..., X; the processing module is further configured to: map, based on an information bit sequence having a length of K, information bits corresponding to the $x^{th}$ group of first bit positions to the second bit positions in the $x^{th}$ group of bit positions of the first sequence, to obtain a second sequence, and perform polar coding on the second sequence to obtain an encoded bit sequence; and the transceiver module is configured to: send one or more bits in the encoded bit sequence to a receiver device.

In another example, the processing module is configured to: determine K first bit positions based on a reliability sequence having a length of $N_1$, and determine K second bit positions based on a reliability sequence having a length of $N_2$,

where $K \leq N_1 < N_2$; the processing module is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; the processing module is further configured to: map, based on an information bit sequence having a length of K, information bits corresponding to the $x^{th}$ group of first bit positions to an $x^{th}$ group of third bit positions in a fifth sequence having a length of $N_2$, and map copy bits of the information bits corresponding to the $x^{th}$ group of first bit positions to the second bit positions in the $x^{th}$ group of bit positions in the fifth sequence, to obtain a sixth sequence, and perform polar coding on the sixth sequence to obtain an encoded bit sequence; and the transceiver module is configured to: send one or more bits in the encoded bit sequence to a receiver device, where the $x^{th}$ group of third bit positions corresponds to the $x^{th}$ group of first bit positions.

In another example, the processing module is configured to: divide bit positions of a seventh sequence having a length of N into X groups of bit positions, and divide A information bits in an information bit sequence having a length of K into X groups of information bits, where a quantity of information bit positions included in an $x^{th}$ group of bit positions is equal to a quantity of information bits included in an $x^{th}$ group of information bits, x=1, 2, ..., X, and $X \geq 2$; the processing module is further configured to: map, in an interleaving manner based on an interleaving pattern, the $x^{th}$ group of information bits to the information bit positions in the $x^{th}$ group of bit positions of the seventh sequence, to obtain an eighth sequence, and perform polar coding on the eighth sequence to obtain an encoded bit sequence; and send one or more bits in the encoded bit sequence to a receiver device.

Optionally, the transceiver module and the processing module of the communication apparatus in the seventh aspect may further perform corresponding functions in the first aspect or any possible design of the first aspect, or perform corresponding functions in the third aspect or any possible design of the third aspect, or perform corresponding functions in the fifth aspect or any possible design of the fifth aspect. For details, refer to detailed descriptions in the method examples. For beneficial effects that can be achieved, refer to the foregoing related content.

According to an eighth aspect, an embodiment of this application provides a communication apparatus. The communication apparatus may be applied to the receiver device in the second aspect, the fourth aspect, or the sixth aspect, to implement a function performed by the receiver device. The communication apparatus may be a receiver device, or may be a chip, a chip system, a system on chip, or the like of the receiver device. The communication apparatus may perform the function performed by the receiver device by hardware, or may perform the function by hardware executing corresponding software. The hardware or the software includes one or more modules corresponding to the foregoing function, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

For example, the transceiver module is configured to: receive a symbol sequence from a transmitter device, where an information bit sequence corresponding to the symbol sequence has a length of K; the processing module is configured to: determine K first bit positions based on a reliability sequence having a length of $N_1$, and determine K second bit positions based on a reliability sequence having a length of $N_2$, where $K \leq N_1 < N_2$; the processing module is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; and the processing module is further configured to decode the symbol sequence based on second bit positions in the X groups of bit positions and the X groups of first bit positions.

In another example, the transceiver module is configured to: receive a symbol sequence from a transmitter device, where an information bit sequence corresponding to the symbol sequence has a length of K; the processing module is configured to: determine K first bit positions based on a reliability sequence having a length of $N_1$, and determine K second bit positions based on a reliability sequence having a length of $N_2$, where $K \leq N_1 < N_2$; the processing module is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; and the processing module is further configured to: decode the symbol sequence based on second bit positions in the X groups of bit positions and X groups of third bit positions, where an $x^{th}$ group of third bit positions corresponds to the $x^{th}$ group of first bit positions, $X \geq 2$, and x=1, 2, ..., X.

In another example, the transceiver module is further configured to: receive a symbol sequence from a transmitter device; the processing module is configured to: divide bit positions of a seventh sequence having a length of N into X groups of bit positions, where X≥2; and the processing module is further configured to: decode the symbol sequence based on information bit positions in the X groups of bit positions.

Optionally, the transceiver module and the processing module of the communication apparatus in the eighth aspect may further perform corresponding functions in the second aspect or any possible design of the second aspect, or perform corresponding functions in the fourth aspect or any possible design of the fourth aspect, or perform corresponding functions in the sixth aspect or any possible design of the sixth aspect. For details, refer to detailed descriptions in the method examples. For beneficial effects that can be achieved, refer to the foregoing related content.

According to a ninth aspect, an embodiment of this application provides a communication apparatus. The communication apparatus includes one or more processors. The one or more processors are configured to run a computer program or instructions, where when the one or more processors execute the computer instruction or the instructions, the communication method according to the first aspect or any possible design of the first aspect is performed, or the communication method according to the second aspect or any possible design of the second aspect is performed, or the communication method according to the third aspect or any possible design of the third aspect is performed, or the communication method according to the fourth aspect or any possible design of the fourth aspect is performed, or the communication method according to the fifth aspect or any possible design of the fifth aspect is performed, or the communication method according to the sixth aspect or any possible design of the sixth aspect is performed.

In a possible design, the communication apparatus further includes one or more memories, the one or more memories are coupled to the one or more processors, and the one or more memories are configured to store the foregoing computer program or instructions. In a possible implementation, the memory is located outside the communication apparatus. In another possible implementation, the memory is located inside the communication apparatus. In this embodiment of this application, the processor and the memory may alternatively be integrated into one component. In other words, the processor and the memory may alternatively be integrated together. In a possible implementation, the communication apparatus further includes a transceiver. The transceiver is configured to receive information and/or send information.

In a possible design, the communication apparatus further includes one or more communication interfaces, the one or more communication interfaces are coupled to the one or more processors, and the one or more communication interfaces are configured to communicate with a module other than the communication apparatus.

According to a tenth aspect, an embodiment of this application provides a communication apparatus. The communication apparatus includes an interface circuit and a logic circuit; the interface circuit is configured to input and/or output information; and the logic circuit is configured to perform the communication method according to the first aspect or any possible design of the first aspect, or perform the communication method according to the second aspect or any possible design of the second aspect, or perform the communication method according to the third aspect or any possible design of the third aspect, or perform the communication method according to the fourth aspect or any possible design of the fourth aspect, perform the communication method according to the fifth aspect or any possible design of the fifth aspect, or perform the communication method according to the sixth aspect or any possible design of the sixth aspect, and perform processing based on information and/or generate information.

According to an eleventh aspect, an embodiment of this application provides a computer-readable storage medium. The computer-readable storage medium stores computer instructions or a program. When the computer instructions or the program is run on a computer, the communication method according to the first aspect or any possible design of the first aspect is performed, or the communication method according to the second aspect or any possible design of the second aspect is performed, the communication method according to the third aspect or any possible design of the third aspect is performed, or the communication method according to the fourth aspect or any possible design of the fourth aspect is performed, or the communication method according to the fifth aspect or any possible design of the fifth aspect is performed, or the communication method according to the sixth aspect or any possible design of the sixth aspect is performed.

According to a twelfth aspect, an embodiment of this application provides a computer program product including computer instructions. When the computer program product is run on a computer, the communication method according to the first aspect or any possible design of the first aspect is performed, or the communication method according to the second aspect or any possible design of the second aspect is performed, or the communication method according to the third aspect or any possible design of the third aspect is performed, the communication method according to the fourth aspect or any possible design of the fourth aspect is performed, the communication method according to the fifth aspect or any possible design of the fifth aspect is performed, or the communication method according to the sixth aspect or any possible design of the sixth aspect is performed.

According to a thirteenth aspect, an embodiment of this application provides a computer program. When the computer program is run on a computer, the communication method according to the first aspect or any possible design of the first aspect is performed, or the communication method according to the second aspect or any possible design of the second aspect is performed, or the communication method according to the third aspect or any possible design of the third aspect is performed, or the communication method according to the fourth aspect or any possible design of the fourth aspect is performed, or the communication method according to the fifth aspect or any possible design of the fifth aspect is performed, or the communication method according to the sixth aspect or any possible design of the sixth aspect is performed.

According to a fourteenth aspect, an embodiment of this application provides a chip, including: a processor, where the processor is coupled to a memory, the memory is configured to store a program or instructions, and when the program or the instruction are executed by the processor, the communication method according to the first aspect or any possible design of the first aspect is performed, or the communication method according to the second aspect or any possible design of the second aspect is performed, or the communication method according to the third aspect or any possible design of the third aspect is performed, or the communication method according to the fourth aspect or any possible design of the fourth aspect is performed, or the communication method according to the fifth aspect or any possible design of the fifth aspect is performed, or the communication method according to the sixth aspect or any possible design of the sixth aspect is performed.

For technical effects brought by any design manner of the ninth aspect to the fourteenth aspect, refer to the technical effects brought by the first aspect or any possible design of the first aspect, or refer to the technical effects brought by the second aspect or any possible design of the second aspect, or refer to the technical effects brought by the third aspect or any possible design of the third aspect, or refer to the technical effects brought by the fourth aspect or any possible design of the fourth aspect, or refer to the technical effects brought by the fifth aspect or any possible design of the fifth aspect, or refer to the technical effects brought by the sixth aspect or any possible design of the sixth aspect. Details are not described.

According to a fifteenth aspect, an embodiment of this application provides a communication system. The communication system may include a communication apparatus configured to perform the first aspect or any possible design of the first aspect and a communication apparatus configured to perform the second aspect or any possible design of the second aspect, or include a communication apparatus configured to perform the third aspect or any possible design of the third aspect and a communication apparatus configured to perform the fourth aspect or any possible design of the fourth aspect, or includes a communication apparatus configured to perform the fifth aspect or any possible design of the fifth aspect and a communication apparatus configured to perform the sixth aspect or any possible design of the sixth aspect.

**BRIEF DESCRIPTION OF DRAWINGS**

FIG. 1 is a diagram of a polar code according to an embodiment of this application;

FIG. 2 is a diagram of a polar code used for HARQ transmission according to an embodiment of this application;

FIG. 3 is a diagram of a polar code supporting self-decoding according to an embodiment of this application;

FIG. 4 is a diagram of a polar code used for HARQ transmission according to an embodiment of this application;

FIG. 5 is a diagram of a communication system according to an embodiment of this application;

FIG. 6 is a diagram of encoding and decoding performed by a transmitter device and a receiver device according to an embodiment of this application;

FIG. 7 is a diagram of a communication apparatus according to an embodiment of this application;

FIG. 8 is a flowchart of a communication method according to an embodiment of this application;

FIG. 9 is a diagram of a polar code used for HARQ transmission according to an embodiment of this application;

FIG. 10 is a flowchart of a communication method according to an embodiment of this application;

FIG. 11 is a diagram of a polar code supporting self-decoding according to an embodiment of this application;

FIG. 12 is a flowchart of a communication method according to an embodiment of this application;

FIG. 13 is a diagram of a transmitter device according to an embodiment of this application;

FIG. 14 is a diagram of a receiver device according to an embodiment of this application; and

FIG. 15 is a diagram of a communication apparatus according to an embodiment of this application.

**DESCRIPTION OF EMBODIMENTS**

Before embodiments of this application are described, technical terms used in embodiments of this application are described.

Polar code (Polar code): The first channel coding scheme that has been rigorously proved to "achieve" the Shannon channel capacity, featuring good error correction performance and low decoding complexity. It has been adopted by the 3rd Generation Partnership Project (third generation partnership project, 3GPP) as a coding scheme for (uplink/downlink) control channels of enhanced mobile broadband (enhanced mobile broadband, eMBB) scenarios of 5th generation (fifth generation, 5G) mobile communication systems.

In the polar code coding scheme, bit positions may be classified into fixed bit positions (or may be referred to as frozen bit positions) and information bit positions based on their reliability. A bit position with lower reliability is a fixed bit position, used to carry a fixed bit (or referred to as a frozen bit, frozen). The fixed bit is typically set to 0, which is known to a transmitter side and a receiver side in actual transmission. A bit position with higher reliability is an information bit position, used to carry an information bit (data) in actual transmission.

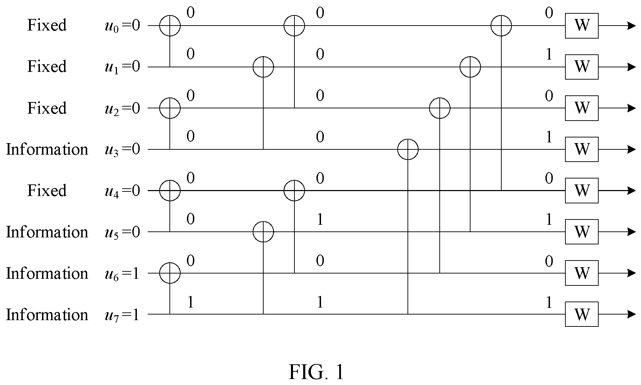

For example, FIG. 1 is a diagram of typical $8 \times 8$ polar code coding. Bit positions with higher reliability (for example, $u_7$, $u_6$, $u_5$, and $u_3$) may be set as information bit positions to carry information bits 0 or 1; and bit positions with lower reliability (for example, $u_4$, $u_2$, $u_1$, and $u_0$) may be set as fixed bit positions to carry fixed bits 0.

Decoding of polar codes: As the polar codes are incorporated into the 5G standard, research on decoding of polar codes becomes a hot topic in communication. Mainstream decoding methods for polar codes may be classified into two types according to decoding order thereof: sequential decoding and non-sequential decoding. Sequential decoding means that a decoder performs decoding by bit positions according to an inherent sequential nature of a polar design. Non-sequential decoding means that a decoder outputs decoding results in parallel based on another structure (for example, a Tanner graph (Tanner graph) or a trellis graph (Trellis graph)) of polar codes.

For sequential decoding, main sequential decoding algorithms of the polar code include successive cancellation (successive cancellation, SC) decoding, successive cancellation list (successive cancellation list, SCL) decoding, successive cancellation stack (successive cancellation stack, SCS) decoding, cyclic redundancy check (cyclic redundancy check, CRC)-aided successive cancellation list (CRC-aided successive cancellation list, CA-SCL) decoding, and the like. For non-sequential decoding, main non-sequential decoding algorithms of the polar code include belief propagation (belief propagation, BP) decoding and the like.

In the foregoing decoding algorithms, SC decoding exhibits poorest decoding performance, SCL decoding has significant improved decoding performance compared with that of SC decoding, and CA-SCL decoding with the addition of CRC enables polar codes to achieve performance superior to that of low-density parity-check codes (low-density parity-check code, LDPC) and Turbo codes. Therefore, SCL decoding and CA-SCL decoding are mainly used in a communication system.

Based on the foregoing description of polar codes, before polar codes are encoded, information bits need to be placed in corresponding information bit positions. In construction of polar codes used for hybrid automatic repeat request (hybrid automatic repeat request, HARQ) transmission or polar codes supporting self-decoding, special design may be made to a bit mapping process, so as to reduce decoding complexity and improve decoding performance.

The following separately describes in detail the polar codes used for HARQ transmission and the polar codes supporting self-decoding.

HARQ transmission: A common technique in wireless communication. In HARQ transmission, forward error correction (forward error correction, FEC) codes can be jointly used with automatic repeat request (automatic repeat request, ARQ) methods. A specific procedure may include the following steps:

Step 1: A transmitter device sends an encoded bit sequence with a high bit rate as initial transmission.
Step 2: A receiver device receives a symbol sequence, and attempts to decode the symbol sequence.

If the receiver device successfully decodes the symbol sequence, the receiver device may feed back an acknowledgment (acknowledgment, ACK) frame to the transmitter device, and the transmitter device may stop sending based on the acknowledgment frame.

If the receiver device fails to decode the symbol sequence, the receiver device may buffer the received symbol sequence, and feed back a negative acknowledgment (negative acknowledgment, NACK) frame to the transmitter device, or may not feed back a negative acknowledgment frame to the transmitter device. When the transmitter device receives a negative acknowledgment frame or receive no acknowledgment frame within specific duration, the transmitter device may continue to send the encoded bit sequence as incremental redundancy (incremental redundancy, IR). The receiver device may jointly decode the sequences from two receptions.

In the foregoing HARQ transmission, compared with a scheme of sending a sequence that would be transmitted in at least two HARQ transmissions all at once, HARQ transmission allows stopping sending once decoding succeeds midway, so that a system throughput can be increased. To be specific, if initial transmission succeeds, retransmission is not required, which saves spectrum resources and improves spectral efficiency. If initial transmission does not succeed, the receiver device may jointly decode the sequences from two receptions, so that error correction performance of a long code can still be achieved.

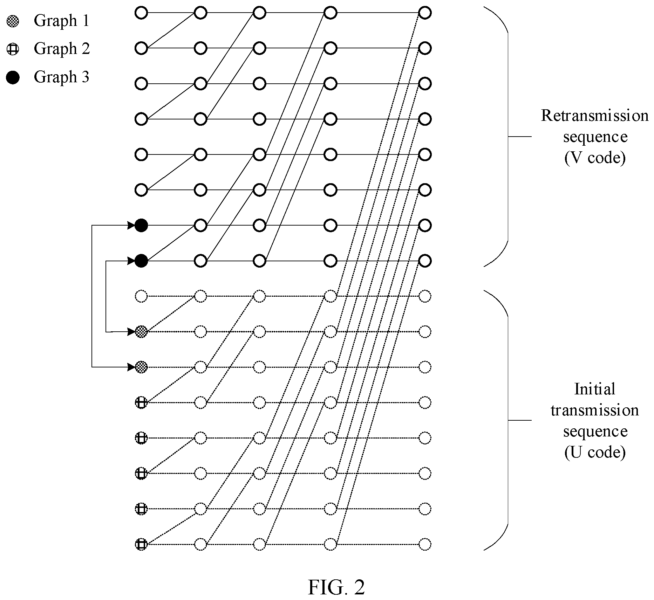

For example, as shown in FIG. 2, a polar code-based IR-HARQ framework is provided. The framework may include an initial transmission sequence (or may be referred to as a U code) having a length of 8 and a retransmission sequence (or may be referred to as a V code) having a length of 8. The initial transmission sequence and the retransmission sequence may be combined into an encoded bit sequence having a length of 16. In the initial transmission sequence, bit positions filled with a graph 1 and a graph 2 are information bit positions. In the retransmission sequence, a bit position filled with a graph 3 is an information bit position. There is a corresponding check relationship between the bit position filled with the graph 3 and the bit position filled with the graph 1. In other words, a same information bit is placed at the bit position filled with the graph 3 and the bit position filled with the graph 1 to which the bit position filled with the graph 3 is mapped.

Based on the polar code described in FIG. 2, the receiver device may decode the initial transmission sequence alone. Bit positions filled with the graph 1 and the graph 2 are information bit positions. If decoding succeeds, the transmitter device may not need to continue to send the encoded bit sequence. If decoding fails, the receiver device may perform decoding by combining the initial transmission sequence and the retransmission sequence, that is, may decode a polar code that has a length of 16 and that is obtained by splicing the initial transmission sequence and the retransmission sequence together. Bit positions filled with the graph 2 and the graph 3 are information bit positions. When the bit position filled with the graph 1 is decoded, a result thereof has been obtained by decoding the same bit position filled with the graph 3, and the bit position filled with the graph 1 becomes a known value and can be understood as a dynamic frozen bit.

Based on the foregoing bit mapping relationship, it can be learned that in the polar code-based IR-HARQ framework, a corresponding check relationship needs to be formed between some information bit positions in the initial transmission sequence and some information bit positions in the retransmission sequence, or this is described as that some information bits need to be mapped to both the initial transmission sequence and the retransmission sequence, so as to ensure that the corresponding information bits are always carried at positions with highest reliability regardless of whether the initial transmission sequence is decoded alone or the initial transmission sequence and the retransmission sequence are decoded jointly, thereby improving decoding performance.

Polar codes supporting self-decoding: Polar codes are relatively amendable to self-decoding requirements. The receiver device can independently perform self-decoding based on received polar codes.

In communication systems, a common coverage enhancement method is to directly send a plurality of redundancy versions (redundancy version, RV), and each RV may be understood as an encoded bit sequence. These RVs generally have the following requirements:

(1) Each RV version needs to be decodable independently.
(2) A plurality of RV versions may be combined to form a long code to enhance decoding.

Compared with sending a longer code alone, a multi-RV transmission solution allows the receiver device to be still capable of performing decoding based on remaining RVs when an RV is completely lost. When a long code is sent alone, the receiver device may not need to have this capability.

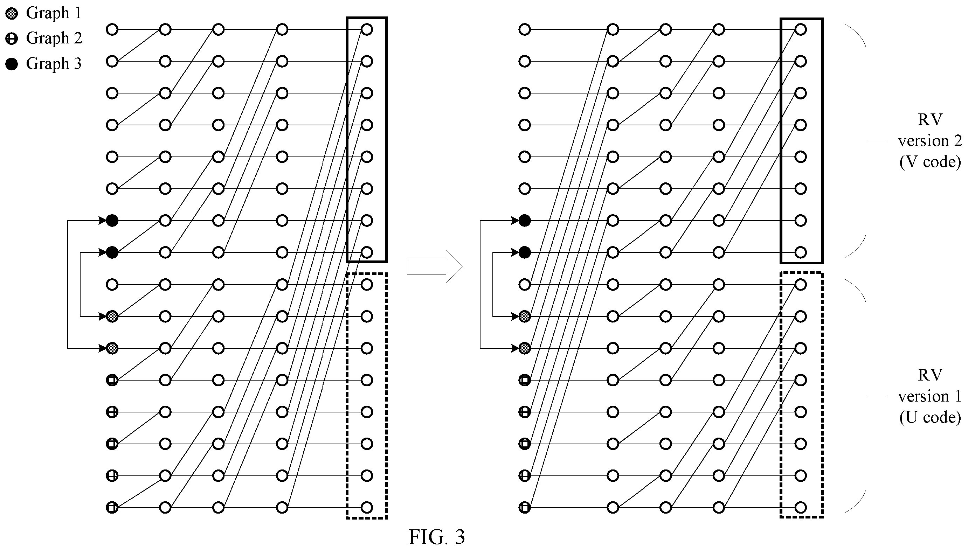

For example, FIG. 3 is a diagram of encoding of a polar code supporting self-decoding. The left side is a diagram of encoding of a common polar code, and a right-side fence graph may be obtained by performing interstage interleaving. It can be learned that, an RV version 1 (or may be referred to as a U code) or an RV version 2 (or may be referred to as a V code) that is received alone may include complete information of all information bits. When a channel condition is good, the receiver device may perform self-decoding based on the RV version 1 or the RV version 2 alone.

In conclusion, for the polar code, regardless of whether the polar code is used for IR-HARQ transmission or supports self-decoding, a feature that a corresponding check relationship exists between some information bit positions of each sent sequence (or described as that a corresponding check relationship exists between some information bit positions of the V code and some information bit positions of the U code) needs to be used. From a perspective of bit mapping, when bit mapping equivalent to that of a long code is constructed, some information bits need to be mapped to all sent sequences (or described as mapping some information bits to both the U code and the V code).

In addition, when a HARQ transmission mechanism is implemented in a communication system, retransmission resources are determined by system scheduling, and may be few or many. Therefore, it is better to support rateless (Rateless) transmission during encoding. To be specific, completing encoding in advance is supported, then a quantity of codeword bits to be sent is determined based on a quantity of retransmission resources, and then a corresponding quantity of codeword bits are extracted from the encoding for sending. In other words, in "Rateless", a bit rate is not determined in advance, but the bit rate is determined after a resource is given.

To meet the foregoing requirement of "mapping some information bits to both the U code and the V code" while encoding supports rateless transmission, the receiver device may use a reverse-order mapping relationship, and check the V code and the U code in a reverse order. In this way, the receiver device may perform mapping bit addressing based on a stack structure. To be specific, when decoding the V code, the receiver device may sequentially push decoding results of mapping bits into a stack. When decoding the U code, the receiver device extracts pre-stored results from the stack in a back-to-front order, to assist in decoding another information bit. In this reverse-order mapping method, the transmitter device or the receiver device only needs to sequentially push or extract data, and does not need to pre-store a specific mapping relationship. This can greatly simplify implementation and reduce implementation complexity.

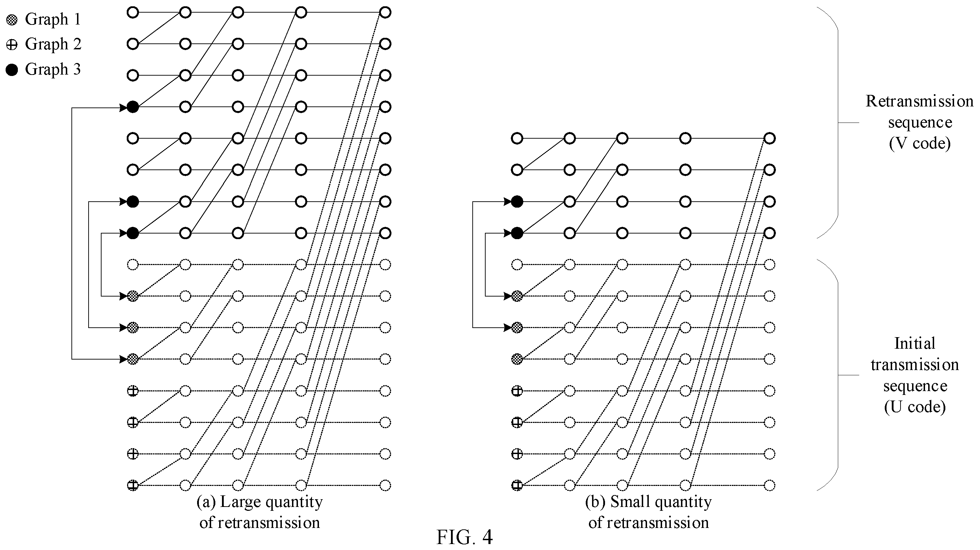

However, in terms of a decoding performance requirement, a mapping bit that is first sent in rateless transmission needs to correspondingly protect a least reliable information bit in the U code, and a mapping bit that is later sent needs to correspondingly protect a secondary least unreliable information bit in the U code. In this way, it can be ensured that a bit with lowest reliability in the U code is always protected regardless of a large quantity of retransmission shown in (a) in FIG. 4 or a small quantity of retransmission shown in (b) in FIG. 4.

However, in the foregoing reverse-order mapping relationship, reverse-order mapping is performed based on a natural order of bit positions, and mapping is not performed based on reliability. That is, encoding performed based on the foregoing reverse-order mapping relationship cannot ensure that a bit with lowest reliability in the U code is always protected regardless of a small quantity of retransmission or a large quantity of reselection.

In addition, if the reverse-order mapping relationship is constructed based on a large quantity of retransmission, a bit position of the U code protected during a small quantity of retransmission may not be a position with lowest reliability, that is, selection is not accurate enough, causing a performance loss. If the mapping relationship is constructed based on a small quantity of retransmission, a stack cannot be used for addressing a check relationship. As a result, decoder implementation is too complex. It is difficult to balance decoding performance when a small quantity of retransmission and a large quantity of retransmission are performed by using a reverse-order mapping relationship.

Therefore, how to perform polar code encoding to implement information bit mapping, reduce decoding complexity, and improve decoding performance becomes a technical problem to be urgently resolved.

To resolve the foregoing technical problem, an embodiment of this application provides a communication method. In the method, a transmitter device may determine K first bit positions based on a reliability sequence having a length of $N_1$, and determine K second bit positions based on a reliability sequence having a length of $N_2$, where $K \leq N_1 < N_2$; divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, a quantity of first bit positions included in an $x^{th}$ group of first bit positions is the same as a quantity of second bit positions included in an $x^{th}$ group of bit positions, $X \geq 2$, and x=1, 2, ..., X; map, based on an information bit sequence having a length of K, information bits corresponding to the $x^{th}$ group of first bit positions to the second bit positions in the $x^{th}$ group of bit positions of the first sequence, to obtain a second sequence; and perform polar coding on the second sequence.

In this embodiment of this application, some information bits (for example, A information bits) in the information bit sequence having a length of K may be mapped to both the A first bit positions and the A second bit positions. In other words, there is a corresponding check relationship between the A first bit positions and the A second bit positions, so that decoding complexity can be reduced, and decoding performance can be improved. In addition, during bit mapping in this application, hierarchical mapping may be further performed. To be specific, A first bit positions are divided into X groups of first bit positions, and bit positions of a first sequence are divided into X groups of bit positions. In this way, a transmitter device may map information bits corresponding to an $x^{th}$ group of first bit positions to second bit positions in an $x^{th}$ group of bit positions of the first sequence, to implement hierarchical mapping. In addition, there is a corresponding check relationship between the $x^{th}$ group of first bit positions and the second bit positions in the $x^{th}$ group of bit positions. Therefore, decoding complexity can be reduced, performance of a small quantity of retransmission and a large quantity of retransmission can be balanced, and decoding performance can be improved.

The following describes implementations of embodiments of this application in detail with reference to accompanying drawings in this specification.

The communication method provided in embodiments of this application may be applied to any communication system. The communication system may be a 3GPP communication system, for example, a long term evolution (long term evolution, LTE) system, or may be a 5th generation (fifth generation, 5G) mobile communication system, an LTE and 5G hybrid networking system, an NR system, an NR vehicle to everything (vehicle to everything, V2X) system, or a device-to-device (device-to-device, D2D) communication system, a machine to machine (machine to machine, M2M) communication system, internet of things (internet of things, IoT), narrowband internet of things (narrow band-internet of things, NB-IoT), global system for mobile communications (global system for mobile communications, GSM), enhanced data rate for GSM evolution (enhanced data rate for GSM evolution, EDGE), wideband code division multiple access (wideband code division multiple access, WCDMA), a code division multiple access 2000 (code division multiple access, CDMA2000) system, a time division-synchronous code division multiple access (time division-synchronization code division multiple access, TD-SCDMA) system, enhanced mobile broadband (enhanced mobile broadband, eMBB), ultra-reliable and ultra-latency communication (ultra-reliable and low-latency communication, URLLC), and enhanced machine-type communication (enhanced machine-type communication, eMTC) and various types of next-generation communication systems, such as a sixth generation (sixth generation, 6G) mobile communication system, or may be a non-terrestrial communication network (non-terrestrial network, NTN) system, a non-3GPP communication system, or the like, which is not limited.

The communication method provided in embodiments of this application may be applied to various communication scenarios. For example, the communication method may be applied to one or more of the following communication scenarios: control channel encoding, data channel encoding, and the like, which is not limited.

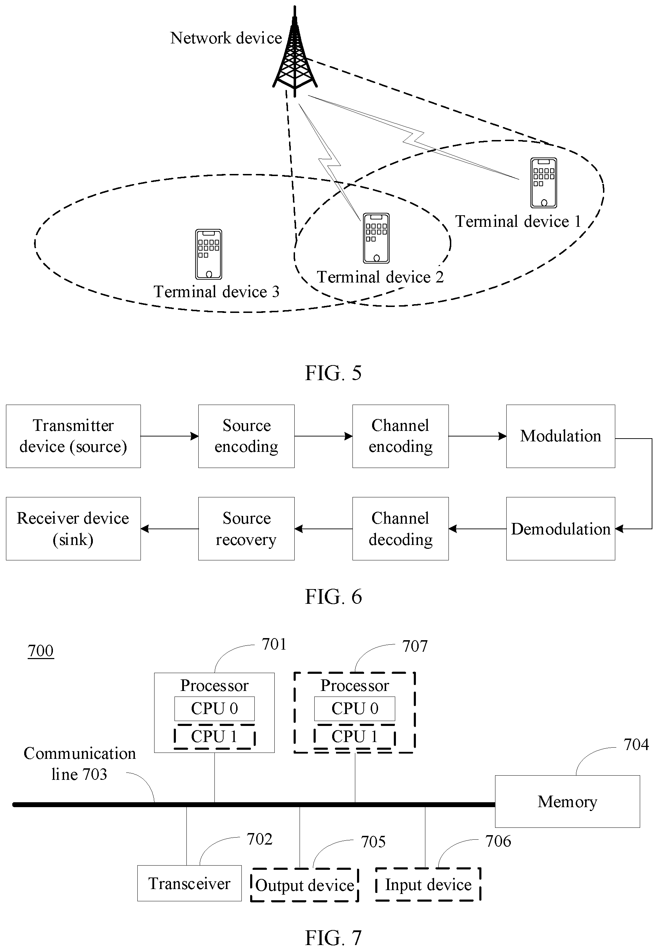

The following uses FIG. 5 as an example to describe the communication system provided in embodiments of this application.

FIG. 5 is a diagram of a communication system according to an embodiment of this application. As shown in FIG. 5, the communication system may include at least one terminal device and at least one network device.

In FIG. 5, the terminal device may be located in beam/cell coverage of the network device, and the network device may provide a communication service for the terminal device. For example, the network device may encode downlink data by using channel encoding, and transmit the downlink data to the terminal device through an air interface after constellation modulation (that is, the network device is a transmitter device, and the terminal device is a receiver device). Alternatively, the terminal device may encode uplink data by using channel encoding, and send the uplink data to the network device through an air interface after constellation modulation (that is, the terminal device is a transmitter device, and the network device is a receiver device). It may be understood that, when a network device communicates with another network device, or a terminal device communicates with another terminal device, communication may also be performed based on channel encoding. In other words, both the transmitter device and the receiver device may be network devices, or both may be terminal devices. This is not limited.

The terminal device in FIG. 5 may be a device having a wireless transceiver function or a chip or a chip system that can be disposed in the device, may allow a user to access a network, and is a device configured to provide voice and/or data connectivity for the user. The terminal device may also be referred to as user equipment (user equipment, UE), a subscriber unit (subscriber unit), a terminal (terminal), a mobile station (mobile station, MS), a mobile terminal (mobile terminal, MT), or the like.

For example, the terminal device in FIG. 5 may be a mobile phone (mobile phone), a tablet computer, or a computer with a wireless transceiver function. Alternatively, the terminal device may be a user station, a mobile station, a remote station, a remote terminal device, a mobile terminal device, a user terminal device, a wireless communication device, a user agent, a user apparatus, a cellular phone, a cordless phone, a session initiation protocol (session initiation protocol, SIP) phone, a wireless local loop (wireless local loop, WLL) station, a personal digital processing (personal digital assistant, PDA), a handheld device having a wireless communication function, a computing device, a processing device connected to a wireless modem, a vehicle-mounted device, a wearable device, a terminal device in the internet of things, household appliance, a virtual reality (virtual reality, VR) terminal, an augmented reality (augmented reality, AR) terminal, a wireless terminal in industrial control, a wireless terminal in self-driving, a wireless terminal in telemedicine, a wireless terminal in a smart grid, a wireless terminal in a smart city (smart city), a wireless terminal in a smart home (smart home), a vehicle having a vehicle-to-vehicle (vehicle-to-vehicle, V2V) communication capability, an intelligent connected vehicle, an uncrewed aerial vehicle having an uncrewed aerial vehicle to uncrewed aerial vehicle (UAV to UAV, U2U) communication capability, a terminal device in a future network, or a terminal device in a future evolved public land mobile network (public land mobile network, PLMN). This is not limited.

The network device in FIG. 5 may be any device that is deployed in an access network and that can perform wireless communication with a terminal device, or may be a chip or a chip system that may be disposed in the device, or may be a logical node or a logical module or a function implemented by software, and may be configured to implement functions such as a radio physical control function, resource scheduling and radio resource management, radio access control, and mobility management. Specifically, the network device may be a device supporting wired access, or may be a device supporting wireless access.

For example, the network device may include one or more access network (access network, AN) or radio access network (radio access network, RAN) nodes. The AN/RAN node may be a continuously evolved NodeB (gNB), a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), a wireless fidelity (wireless fidelity, Wi-Fi) access point (access point, AP), or the like.

In another example, the network device may include a baseband unit (baseband unit, BBU) and a remote radio unit (remote radio unit, RRU). The BBU and the RRU may be placed at different places. For example, the RRU is remote and placed in a heavy-traffic area, and the BBU is placed in a central equipment room. Alternatively, the BBU and the RRU may be placed in a same equipment room. Alternatively, the BBU and the RRU may be different components in a rack.

In still another example, the network device may be a device including a central unit (centralized unit, CU) node, a distributed unit (distributed unit, DU) node, or a CU node and a DU node. For example, the network device may be divided into a CU and a DU from a perspective of logical functions. Some protocol layer functions are centrally controlled by the CU, and remaining or all protocol layer functions are distributed in the DU, and the CU centrally controls the DU. Further, the central unit CU may be further divided into a control plane (CU-CP) and a user plane (CU-UP). In different systems, a CU (including a CU-CP or a CU-UP) or a DU may have different names. For example, in an open radio access network (open radio access network, O-RAN) system, the CU may also be referred to as an O-CU (open CU), the DU may also be referred to as an O-DU, the CU-CP may also be referred to as an O-CU-CP, and the CU-UP may also be referred to as an O-CU-UP.

Based on the foregoing descriptions of the terminal device and the network device, optionally, the communication method provided in embodiments of this application may be implemented by the terminal device or the network device, or may be implemented by a component of the terminal device or the network device, for example, implemented by an application-specific integrated circuit (application-specific integrated circuit, ASIC), a field programmable gate array (field programmable gate array, FPGA), or software (such as program code in a memory) deployed in the terminal device or the network device. This is not limited.

Optionally, in this embodiment of this application, the transmitter device (or referred to as a source) and the receiver device (or referred to as a sink) may perform encoding and decoding by using a procedure shown in FIG. 6.

The transmitter device may perform source encoding on a bit generated by the transmitter device, to obtain a source bit stream, perform channel encoding on the source bit stream through channel encoding, and then send a modulation symbol to the receiver device through a noisy channel after modulation. When receiving the modulation symbol through the noisy channel, the receiver device may perform demodulation, then perform channel decoding to recover the source bit stream, and then perform source recovery to obtain a decoding result.

During specific implementation, as shown in FIG. 5, for example, each terminal device or each network device may use a composition structure shown in FIG. 7, or include components shown in FIG. 7. FIG. 7 is a diagram of composition of a communication apparatus 700 according to an embodiment of this application. The communication apparatus 700 may be a terminal device, or a chip or a system on chip in the terminal device; or may be a network device, or a chip or a system on chip in the network device. As shown in FIG. 7, the communication apparatus 700 includes a processor 701, a transceiver 702, and a communication line 703.

Further, the communication apparatus 700 may further include a memory 704. The processor 701, the memory 704, and the transceiver 702 may be connected through the communication line 703.

The processor 701 is a central processing unit (central processing unit, CPU), a general-purpose processor, a network processor (network processor, NP), a digital signal processor (digital signal processor, DSP), a microprocessor, a microcontroller, a programmable logic device (programmable logic device, PLD), or any combination thereof. The processor 701 may alternatively be another apparatus having a processing function, for example, a circuit, a component, or a software module. This is not limited.

The transceiver 702 is configured to communicate with another device or another communication network. The another communication network may be an Ethernet, a radio access network (radio access network, RAN), a wireless local area network (wireless local area network, WLAN), or the like. The transceiver 702 may be a module, a circuit, a transceiver, or any apparatus that can implement communication.

The communication line 703 is configured to transfer information between the components included in the communication apparatus 700.

The memory 704 is configured to store instructions. The instructions may be computer programs.

The memory 704 may be a read-only memory (read-only memory, ROM) or another type of static storage device that can store static information and/or instructions; may be a random access memory (random access memory, RAM) or another type of dynamic storage device that can store information and/or instructions; or may be an electrically erasable programmable read-only memory (electrically erasable programmable read-only memory, EEPROM), a compact disc read-only memory (compact disc read-only memory, CD-ROM) or another compact disc storage, an optical disc storage (including a compact optical disc, a laser disc, an optical disc, a digital versatile disc, a Blu-ray disc, or the like), a magnetic disk storage medium or another magnetic storage device, or the like. This is not limited.

It should be noted that the memory 704 may exist independently of the processor 701, or may be integrated with the processor 701. The memory 704 may be configured to store instructions, program code, some data, or the like. The memory 704 may be located inside the communication apparatus 700, or may be located outside the communication apparatus 700. This is not limited. The processor 701 is configured to execute the instructions stored in the memory 704, to implement a communication method provided in the following embodiment of this application.

In an example, the processor 701 may include one or more CPUs, for example, a CPU 0 and a CPU 1 in FIG. 7.

In an optional implementation, the communication apparatus 700 includes a plurality of processors. For example, the communication apparatus 700 may further include a processor 707 in addition to the processor 701 in FIG. 7.

In an optional implementation, the communication apparatus 700 further includes an output device 705 and an input device 706. For example, the input device 706 is a device like a keyboard, a mouse, a microphone, or a joystick, and the output device 705 is a device like a display or a speaker (speaker).

It should be noted that the communication apparatus 700 may be a desktop computer, a portable computer, a network server, a mobile phone, a tablet computer, a wireless terminal, an embedded device, a chip system, or a device having a structure similar to that in FIG. 7. In addition, the composition structure shown in FIG. 7 does not constitute a limitation on the communication apparatus. In addition to the components shown in FIG. 7, the communication apparatus may include more or fewer components than those shown in the figure, a combination of some components, or splits from some components, or a different component layout.

In this embodiment of this application, the chip system may include a chip, or may include a chip and another discrete component.

In addition, actions, terms, and the like in embodiments of this application may be mutually referenced. This is not limited. In embodiments of this application, names of messages exchanged between devices, names of parameters in the messages, or the like are merely examples. Other names may alternatively be used during specific implementation. This is not limited.

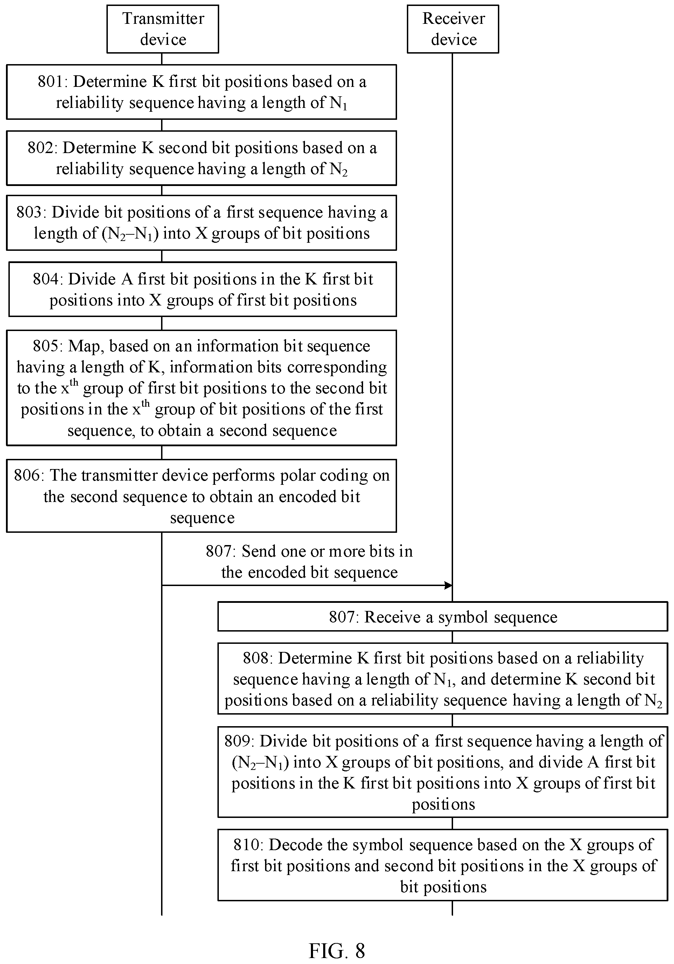

With reference to the communication system shown in FIG. 5, the following describes a communication method provided in an embodiment of this application with reference to FIG. 8. The transmitter device may be any terminal device or network device in the communication system shown in FIG. 5, and the receiver device may also be any terminal device or network device in the communication system shown in FIG. 5. The transmitter device or the receiver device described in the following embodiment may have the components shown in FIG. 7.

A polar code used for HARQ transmission is used as an example below. Refer to FIG. 8. A communication method provided in an embodiment of this application is described. As shown in FIG. 8, the method may include the following steps:

Step 801: A transmitter device determines K first bit positions based on a reliability sequence having a length of $N_1$.

$K \leq N_1$, and both K and $N_1$ are positive integers.

A value of K may be determined based on a length of an information bit sequence, that is, the length of the information bit sequence may be determined as K.

For example, the information bit sequence may include an information bit and a cyclic redundancy check (cyclic redundancy check, CRC) bit, and K may be a sum of a quantity of information bits and a quantity of CRC bits included in the information bit sequence.

A specific value of $N_1$ may be determined based on a length of an initial transmission sequence. To be specific, the length of the initial transmission sequence may be determined as $N_1$, so as to determine the reliability sequence having a length of $N_1$.

The reliability sequence may indicate reliability corresponding to each bit position in the sequence. A larger value of reliability indicates that a bit position corresponding to the reliability is more reliable.

Optionally, the reliability sequence may be predefined in a protocol. The transmitter device may determine $N_1$ based on the length of the initial transmission sequence, to select a reliability sequence having a length of $N_1$ from one or more reliability sequences predefined in a protocol.

For example, the transmitter device determines that $N_1$ is 16. A reliability sequence having a length of 16 may be a reliability sequence shown in the following Table 1, where $W(Q_i^{Nmax})$ represents reliability, and $Q_i^{Nmax}$ represents a bit position corresponding to the reliability.

Table 1

| $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ |
|---|---|---|---|---|---|---|---|
| 0 | 0 | 4 | 8 | 8 | 6 | 12 | 11 |
| 1 | 1 | 5 | 3 | 9 | 10 | 13 | 13 |
| 2 | 2 | 6 | 5 | 10 | 12 | 14 | 14 |
| 3 | 4 | 7 | 9 | 11 | 7 | 15 | 15 |

It may be understood that Table 1 is defined starting from bit 0, or may be defined starting from bit 1. To be specific, 0, 1, ..., and 15 may be respectively replaced with 1, 2, ..., and 16. This is not limited.

Refer to the foregoing reliability sequence. The transmitter device may select, in descending order of reliability (or from high to low of reliability), the first K bit positions of the reliability sequence having a length of $N_1$ as the K first bit positions.

For example, the reliability sequence is the reliability sequence whose length $N_1$ is 16 described in Table 1 and the length K of the information bit sequence is 15. Based on the reliability sequence, it may be determined that the K first bit positions are {15 14 13 11 7 12 10 6 9 5 3 8 4 2 1}.

Optionally, the K first bit positions may be denoted as $\bar{Q}_{I_1}^{N_1}$, representing a first bit position set $I_1$ in a sequence having a length of $N_1$, where $I_1$ may include the K first bit positions.

For example, $\bar{Q}_{I_1}^{N_1} = \{15\ 14\ 13\ 11\ 7\ 12\ 10\ 6\ 9\ 5\ 3\ 8\ 4\ 2\ 1\}$.

Step 802: The transmitter device determines K second bit positions based on a reliability sequence having a length of $N_2$.

$N_1 < N_2$, and $N_2$ is a positive integer.

For example, $N_2 = 2N_1$.

A specific value of $N_2$ may be determined based on a total length of the initial transmission sequence and a retransmission sequence. To be specific, the total length of the initial transmission sequence and the retransmission sequence may be determined as $N_2$, so as to determine the reliability sequence having a length of $N_2$.

Optionally, the transmitter device may determine $N_2$ based on the total length of the initial transmission sequence and the retransmission sequence, to select a reliability sequence having a length of $N_2$ from one or more reliability sequences predefined in a protocol.

For example, the transmitter device determines that $N_2$ is 32. A reliability sequence having a length of 32 may be a reliability sequence shown in the following Table 2, where $W(Q_i^{Nmax})$ represents reliability, and $Q_i^{Nmax}$ represents a bit position corresponding to the reliability.

Table 2

| $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ | $W(Q_i^{Nmax})$ | $Q_i^{Nmax}$ |
|---|---|---|---|---|---|---|---|
| 0 | 0 | 8 | 9 | 16 | 7 | 24 | 22 |
| 1 | 1 | 9 | 6 | 17 | 11 | 25 | 28 |
| 2 | 2 | 10 | 17 | 18 | 19 | 26 | 15 |
| 3 | 4 | 11 | 10 | 19 | 13 | 27 | 23 |
| 4 | 8 | 12 | 18 | 20 | 14 | 28 | 27 |
| 5 | 16 | 13 | 12 | 21 | 21 | 29 | 29 |
| 6 | 3 | 14 | 20 | 22 | 26 | 30 | 30 |
| 7 | 5 | 15 | 24 | 23 | 25 | 31 | 31 |

It may be understood that Table 2 is defined starting from bit 0, or may be defined starting from bit 1. To be specific, 0, 1, ..., and 31 may be respectively replaced with 1, 2, ..., and 32. This is not limited.

Refer to the foregoing reliability sequence. The transmitter device may select, in descending order of reliability, the first K bit positions of the reliability sequence having a length of $N_2$ as the K second bit positions.

For example, the reliability sequence is the reliability sequence whose length $N_2$ is 32 described in Table 2 and the length K of the information bit sequence is 15. Based on the reliability sequence, it may be determined that the K second bit positions are {31 30 29 27 23 15 28 22 25 26 21 14 13 19 11}.

Optionally, the K second bit positions may be denoted as $\overline{Q}_{I_2}^{N_2}$, representing a second bit position set $I_2$ in a sequence having a length of $N_2$, where $I_2$ may include the K second bit positions.

For example, $\overline{Q}_{I_2}^{N_2} = \{31\ 30\ 29\ 27\ 23\ 15\ 28\ 22\ 25\ 26\ 21\ 14\ 13\ 19\ 11\}$.

Optionally, there is no strict limitation on an execution sequence of step 801 and step 802. To be specific, step 801 may be performed first and then step 802 is performed, or step 802 may be performed first and then step 801 is performed, or step 801 and step 802 may be performed at the same time, which is not limited.

Step 803: The transmitter device divides bit positions of a first sequence having a length of $(N_2-N_1)$ into X groups of bit positions.

The transmitter device may divide the bit positions of the first sequence into the X groups of bit positions, or the transmitter device may interleave the first sequence, and divide bit positions of an interleaved first sequence into the X groups of bit positions.

Optionally, the transmitter device may interleave the first sequence based on a third interleaving pattern, to obtain the interleaved first sequence.

Optionally, the third interleaving pattern may be one or more of the following: a random interleaving pattern, a triangular interleaving pattern, a row-column interleaving pattern, a reverse-order interleaving pattern, or the like. This is not limited.

For example, the transmitter device may interleave the first sequence based on the third interleaving pattern at a granularity of bit position, to obtain the interleaved first sequence.

In another example, the transmitter device may alternatively perform interleaving based on the third interleaving pattern at a granularity of sub-block. To be specific, the first sequence may be divided into M sub-blocks, and the M sub-blocks are interleaved, to obtain the interleaved first sequence.

Each sub-block may include one or more bit positions. The transmitter device may divide the bit positions of the first sequence into M sub-blocks based on reliability (for example, in descending order or in ascending order), or may divide the bit positions of the first sequence into M sub-blocks based on a natural order of numbers (for example, in descending order or in ascending order). This is not limited.

For example, the third interleaving pattern may be any one of the following three sub-block interleaving patterns: [0 1 2 4 3 5 6 7 8 16 9 17 10 18 11 19 12 20 13 21 14 22 15 23 24 25 26 28 27 29 30 31], or [0 4 8 12 1 5 9 13 2 6 10 14 3 7 11 15 16 20 24 28 17 21 25 29 18 22 26 30 19 23 27 31], or [0 8 16 24 1 9 17 25 2 10 18 26 3 11 19 27 4 12 20 28 5 13 21 29 6 14 22 30 7 15 23 31].

The first sub-block interleaving pattern has good compatibility, for example, has good compatibility with an NR communication system. The second sub-block interleaving pattern has good performance. Implementation of the third sub-block interleaving pattern is simple.

It may be understood that the sub-block interleaving pattern is defined starting from bit 1, or may be defined starting from bit 0. To be specific, 1, 2, ..., and 32 may be respectively replaced with 0, 1, ..., and 31. This is not limited.

Based on the foregoing descriptions of the first sequence and the interleaved first sequence, optionally, the transmitter device may divide the bit positions of the first sequence (or the interleaved first sequence) into the X groups of bit positions based on preset configuration information or a retransmission resource.

The transmitter device may divide the bit positions of the first sequence (or the interleaved first sequence) into the X groups of bit positions at a granularity of bit position, where the $x^{th}$ group of bit positions includes Zx bit positions, and Zx is a positive integer. Alternatively, the transmitter device may divide the bit positions of the first sequence (or the interleaved first sequence) into the X groups of bit positions at a granularity of sub-block, where the $x^{th}$ group of bit positions includes Yx sub-blocks, and Yx is a positive integer; and x=1, 2, ..., X.

For example, the transmitter device may determine a specific value of X based on preset configuration information, and may further determine a quantity of bit positions or sub-blocks included in each group of bit positions.

For example, the preset configuration information indicates that the value of X is 2, and indicates that a first group of bit positions includes $(N_2-N_1)/8$ bit positions of the first sequence (or the interleaved first sequence), and a second group of bit positions includes $7(N_2-N_1)/8$ bit positions of the first sequence (or the interleaved first sequence). If the first sequence (or the interleaved first sequence) includes $(N_2-N_1)=64$ bit positions, it may be determined that the first group of bit positions includes 8 bit positions, and the second group of bit positions includes 56 bit positions.

$(N_2-N_1)/8$ bit positions and $7(N_2-N_1)/8$ bit positions may also be converted into sub-blocks for description. For example, if the first sequence (or the interleaved first sequence) is divided into $(N_2-N_1)/2$ sub-blocks. In other words, one sub-block includes 2 bit positions. $(N_2-N_1)/8$ bit positions may also be described as $(N_2-N_1)/16$ sub-blocks, and $7(N_2-N_1)/8$ bit positions may also be described as $7(N_2-N_1)/16$ sub-blocks.

Optionally, the preset configuration information may be predefined in a protocol, or may be indicated by another device to the transmitter device. This is not limited.

In another example, the transmitter device may alternatively divide the bit positions of the first sequence (or the interleaved first sequence) into the X groups of bit positions based on a retransmission resource.

The transmitter device may determine, based on a retransmission resource for a first retransmission, a quantity of bit positions (or sub-blocks) for the first retransmission, in other words, determine a quantity of bit positions (or sub-blocks) included in a first group of bit positions; determine, based on a retransmission resource for a second retransmission, a quantity of bit positions (or sub-blocks) for the second retransmission, in other words, determine a quantity of bit positions (or sub-blocks) included in a second group of bit positions; ...; and determine a quantity of bit positions (or sub-blocks) for the second retransmission based on a retransmission resource for the $X^{th}$ retransmission, in other words, determine a quantity of bit positions (or sub-blocks) included in an $X^{th}$ group of bit positions.

For example, if the transmitter device determines, based on the retransmission resource for the first retransmission, that 4 sub-blocks need to be retransmitted, it may be determined that the first group of bit positions includes 4 sub-blocks. If the transmitter device determines, based on the retransmission resource for the second retransmission, that 12 sub-blocks need to be retransmitted, it may be determined that the second group of bit positions includes 12 sub-blocks.

Based on the foregoing description of the X groups of bit positions, in a possible design, a length of at least one group of bit positions in the X groups of bit positions is an integer power of 2.

For example, a length of a first group of bit positions in the X groups of bit positions is an integer power of 2.

In another possible design, a length from the first group of bit positions to an $x'^{th}$ group of bit positions in the X groups of bit positions is an integer power of 2, where $2 \leq x' \leq X$.

For example, a length from the first group of bit positions to a second group of bit positions in the X groups of bit positions is an integer power of 2, or a length from the first group of bit positions to a third group of bit positions in the X groups of bit positions is an integer power of 2. This is not limited.

Based on the foregoing description, for example, the value of X may be any one of the following: 2, 3, 4, and the like. This is not limited.

In a first example, X is equal to 2. The first group of bit positions in the X groups of bit positions may include $(N_2-N_1)/8$ bit positions of the first sequence (or the interleaved first sequence), and the second group of bit positions may include $7(N_2-N_1)/8$ bit positions of the first sequence (or the interleaved first sequence).

$(N_2-N_1)/8$ bit positions and $7(N_2-N_1)/8$ bit positions may also be converted into sub-blocks for description. For example, if the first sequence (or the interleaved first sequence) is divided into $(N_2-N_1)/2$ sub-blocks. In other words, one sub-block includes 2 bit positions. $(N_2-N_1)/8$ bit positions may also be described as $(N_2-N_1)/16$ sub-blocks, and $7(N_2-N_1)/8$ bit positions may also be described as $7(N_2-N_1)/16$ sub-blocks.

For example, the first sequence (or the interleaved first sequence) includes 32 sub-blocks. The last four sub-blocks may be divided into one group, and remaining sub-blocks may be divided into one group, so as to minimize a chip area.

In a second example, X is equal to 3. The first group of bit positions in the X groups of bit positions may include $(N_2-N_1)/8$ bit positions of the first sequence (or the interleaved first sequence), the second group of bit positions may include $(N_2-N_1)/8$ bit positions of the first sequence (or the interleaved first sequence), and the third group of bit positions may include $3(N_2-N_1)/4$ bit positions of the first sequence (or the interleaved first sequence).

$(N_2-N_1)/8$ bit positions and $3(N_2-N_1)/4$ bit positions may also be converted into sub-blocks for description. For details, refer to related descriptions in the first example. Details are not described again.

For example, the first sequence (or the interleaved first sequence) includes 32 sub-blocks, the last four sub-blocks may be divided into one group, other four sub-blocks may be divided into one group, and remaining sub-blocks may be divided into one group. Compared with the first example, although the chip area may be increased, decoding performance can be further improved.

In a third example, X is equal to 4. The first group of bit positions in the X groups of bit positions may include $(N_2-N_1)/8$ bit positions of the first sequence (or the interleaved first sequence), the second group of bit positions may include $(N_2-N_1)/8$ bit positions of the first sequence (or the interleaved first sequence), the third group of bit positions may include $(N_2-N_1)/4$ bit positions of the first sequence (or the interleaved first sequence), and a fourth group of bit positions may include $(N_2-N_1)/2$ bit positions of the first sequence (or the interleaved first sequence).

$(N_2-N_1)/8$ bit positions, $(N_2-N_1)/4$ bit positions, and $(N_2-N_1)/2$ bit positions may also be converted into sub-blocks for description. For details, refer to related descriptions in the first example. Details are not described again.

For example, the first sequence (or the interleaved first sequence) includes 32 sub-blocks, the last four sub-blocks may be divided into one group, other four sub-blocks may be divided into one group, other eight sub-blocks may be divided into one group, and remaining sub-blocks may be divided into one group. Compared with the first example and the second example, a balance between the chip area and the decoding performance can be achieved.

In a fourth example, X is equal to 2. The first group of bit positions in the X groups of bit positions may include $(N_2-N_1)/4$ bit positions of the first sequence (or the interleaved first sequence), and the second group of bit positions may include $3(N_2-N_1)/4$ bit positions of the first sequence (or the interleaved first sequence).

$(N_2-N_1)/4$ bit positions and $3(N_2-N_1)/4$ bit positions may also be converted into sub-blocks for description. For details, refer to related descriptions in the first example. Details are not described again.

For example, the first sequence (or the interleaved first sequence) includes 32 sub-blocks, the last eight sub-blocks may be divided into one group, and remaining sub-blocks may be divided into one group. Compared with the third example, on the basis that the balance between the chip area and the decoding performance is achieved, better performance can be preferentially ensured during retransmission of $(N_2-N_1)/4$ bit positions.

Based on the foregoing description of the X groups of bit positions, the transmitter device may group the first sequence or the interleaved first sequence based on any one of the following three possible designs, to obtain the X groups of bit positions.

In a first possible design, the transmitter device may group the first sequence based on reliability, to obtain the X groups of bit positions.

For example, reliability of an $(x+1)^{th}$ group of bit positions is higher than reliability of the $x^{th}$ group of bit positions, where x=1, 2, ..., X. That is, a first group of bit positions is $Z_1$ least reliable bit positions (or $Y_1$ sub-blocks) in the X groups of bit positions, a second group of bit positions is $Z_2$ least reliable bit positions (or $Y_2$ sub-blocks) in (the X group of bit positions - the first group of bit positions), ..., and the $X^{th}$ group of bit positions is $Z_X$ least reliable bit positions (or $Y_X$ sub-blocks) in (the X group of bit positions - (the first group of bit positions + the second group of bit positions + ... + an $(X-1)^{th}$ group of bit positions)).

For example, X=2, and the first sequence is sorted as {15 14 13 11 7 12 10 6 9 5 3 8 4 2 1 0} in descending order of reliability. The first sequence may be divided into the following two groups of bit positions: {1 0} and {15 14 13 11 7 12 10 6 9 5 3 8 4 2 1 0}.

In another example, reliability of an $(x+1)^{th}$ group of bit positions is lower than reliability of the $x^{th}$ group of bit positions, where x=1, 2, ..., X. That is, a first group of bit positions is $Z_1$ most reliable bit positions (or $Y_1$ sub-blocks) in the X groups of bit positions, a second group of bit positions is $Z_2$ most reliable bit positions (or $Y_2$ sub-blocks) in (the X group of bit positions - the first group of bit positions), ..., and the $X^{th}$ group of bit positions is $Z_X$ most reliable bit positions (or $Y_X$ sub-blocks) in (the X group of bit positions - (the first group of bit positions + the second group of bit positions + ... + an $(X-1)^{th}$ group of bit positions)).

For example, X=2, and the first sequence is sorted as {15 14 13 11 7 12 10 6 9 5 3 8 4 2 1 0} in descending order of reliability. The first sequence may be divided into the following two groups of bit positions: {15 14} and {13 11 7 12 10 6 9 5 3 8 4 2 1 0}.

In a second possible design, the transmitter device may alternatively group the first sequence in a natural order of numbers, to obtain the X groups of bit positions.

For example, a number of an $(x+1)^{th}$ group of bit positions is greater than a number of the $x^{th}$ group of bit positions, where x=1, 2, ..., X. That is, a first group of bit positions is $Z_1$ bit positions (or $Y_1$ sub-blocks) with a smallest number in the X groups of bit positions, a second group of bit positions is $Z_2$ bit positions (or $Y_2$ sub-blocks) with a smallest number in (the X group of bit positions - the first group of bit positions), ..., and the $X^{th}$ group of bit positions is $Z_X$ bit positions (or $Y_X$ sub-blocks) with a smallest number in (the X group of bit positions - (the first group of bit positions + the second group of bit positions + ... + an $(X-1)^{th}$ group of bit positions)).

For example, X=2, and the first sequence is sorted as {0 1 2 3 4 5 6 7 8 9 10 11 12 13 14 15} in ascending order of numbers. The first sequence may be divided into the following two groups of bit positions: {0 1} and {2 3 4 5 6 7 8 9 10 11 12 13 14 15}.

In another example, numbers of the $(x+1)^{th}$ group of bit positions are less than numbers of the $x^{th}$ group of bit positions, where x=1, 2, ..., X. That is, a first group of bit positions is $Z_1$ bit positions (or $Y_1$ sub-blocks) with a largest number in the X groups of bit positions, a second group of bit positions is $Z_2$ bit positions (or $Y_2$ sub-blocks) with a largest number in (the X group of bit positions - the first group of bit positions), ..., and the $X^{th}$ group of bit positions is $Z_X$ bit positions (or $Y_X$ sub-blocks) with a largest number in (the X group of bit positions - (the first group of bit positions + the second group of bit positions + ... + an $(X-1)^{th}$ group of bit positions)).

For example, X=2, and the first sequence is sorted as {0 1 2 3 4 5 6 7 8 9 10 11 12 13 14 15} in ascending order of numbers. The first sequence may be divided into the following two groups of bit positions: {14 15} and {0 1 2 3 4 5 6 7 8 9 10 11 12 13}.

In a third possible design, the transmitter device may group the interleaved first sequence in an interleaved order, to obtain the X groups of bit positions.

For example, the transmitter device may group the interleaved first sequence in a front-to-back order. To be specific, a first group of bit positions is $Z_1$ foremost bit positions (or $Y_1$ sub-blocks) in the interleaved first sequence, a second group of bit positions is $Z_2$ foremost bit positions (or $Y_2$ sub-blocks) other than the first group of bit positions in the interleaved first sequence, ..., and the $X^{th}$ group of bit positions is $Z_X$ foremost bit positions (or $Y_X$ sub-blocks) other than (the first group of bit positions + the second group of bit positions + ... + an $(X-1)^{th}$ group of bit positions) in the interleaved first sequence.

For example, X=2, and the interleaved first sequence is {13 11 8 9 4 7 2 3 15 10 14 1 5 0 6 12} in front-to-back order. The first sequence may be divided into the following two groups of bit positions: {13 11} and {8 9 4 7 2 3 15 10 14 1 5 0 6 12}.

In another example, the transmitter device may alternatively group the interleaved first sequence in a back-to-front order. To be specific, a first group of bit positions is $Z_1$ rearmost bit positions (or $Y_1$ sub-blocks) in the interleaved first sequence, a second group of bit positions is $Z_2$ rearmost bit positions (or $Y_2$ sub-blocks) other than the first group of bit positions in the interleaved first sequence, ..., and the $X^{th}$ group of bit positions is $Z_X$ rearmost bit positions (or $Y_X$ sub-blocks) other than (the first group of bit positions + the second group of bit positions + ... + an $(X-1)^{th}$ group of bit positions) in the interleaved first sequence.

For example, X=2, and the interleaved first sequence is {13 11 8 9 4 7 2 3 15 10 14 1 5 0 6 12} in front-to-back order. The first sequence may be divided into the following two groups of bits: {6 12} and {13 11 8 9 4 7 2 3 15 10 14 1 5 0}.

Based on the foregoing description of the X groups of bit positions, the X groups of bit positions may include A second bit positions in the K second bit positions, A≤K, and A and X are both positive integers.

In a first possible design, the A second bit positions are determined based on the K first bit positions and the K second bit positions.

For example, the transmitter device may determine the K third bit positions based on the K first bit positions, and determine the A second bit positions based on the K third bit positions.

A number of a third bit position corresponding to a first bit position numbered i is $i+N_2-N_1$, and $0 \le i \le N_1-1$. The A second bit positions are bit positions that are in the K second bit positions and whose numbers are different from those of the K third bit positions.

Optionally, the K first bit positions may be denoted as $\overline{Q}_{I_1}^{N_1}$, the K second bit positions may be denoted as $\overline{Q}_{I_2}^{N_2}$, and a number i of each first bit position in $\overline{Q}_{I_1}^{N_1}$ may be added to $(N_2-N_1)$ to obtain the K third bit positions $\overline{Q}_{I_1}^{N_2}$. In this way, the A second bit positions may be denoted as $\overline{Q}_{cp}^{v}=(\overline{Q}_{I_2}^{N_2}-\overline{Q}_{I_1}^{N_2})$ to represent bit positions that are in the K second bit positions and whose numbers are different from those of the K third bit positions.

For example, K is 15, $N_1$ is 16, and $N_2$ is 32. Assuming that the K first bit positions $\overline{Q}_{I_1}^{N_1}$ are {15 14 13 11 7 12 10 6 9 5 3 8 4 2 1}, and the K second bit positions $\overline{Q}_{I_2}^{N_2}$ are {31 30 29 27 23 15 28 22 25 26 21 14 13 19 11}, 16 (that is, $N_2-N_1$) may be added to a number i of each first bit position in $\overline{Q}_{I_1}^{N_1}$ to obtain the K third bit positions $\overline{Q}_{I_1}^{N_2}=\{31\ 30\ 29\ 27\ 23\ 28\ 26\ 22\ 25\ 21\ 19\ 24\ 20\ 18\ 17\}$, and the A second bit positions may be denoted as $\overline{Q}_{cp}^{v}=(\overline{Q}_{I_2}^{N_2}-\overline{Q}_{I_1}^{N_2})=\{15\ 14\ 13\ 11\}$.

It should be noted that, in the first possible design, a manner of determining the A second bit positions is described by using an example in which definition starts from bit 0. It may be understood that when definition starts from bit 1, a number of a third bit position corresponding to a first bit position numbered i is $i+N_2-N_1$, where $1 \le i \le N_1$.

In a second possible design, the A second bit positions are A bit positions whose numbers are less than $N_2-N_1$ in the K second bit positions.

For example, K is 15, $N_1$ is 16, and $N_2$ is 32. Assuming that 15 (that is, K) second bit positions are {31 30 29 27 23 15 28 22 25 26 21 14 13 19 11}, it may be determined that bit positions whose numbers are less than 16 (that is, $N_2-N_1$) in the 15 second bit positions are {15 14 13 11}, that is, the A second bit positions are {15 14 13 11}.

It should be noted that in the second possible design, a manner of determining the A second bit positions is described by using an example in which definition starts from bit 0. It may be understood that when definition starts from bit 1, the A second bit positions are A bit positions whose numbers are less than or equal to $N_2-N_1$ in the K second bit positions.

Based on the foregoing description of the A second bit positions, a distribution status of the A second bit positions in the X groups of bit positions may be determined. To be specific, a second bit position included in each group of bit positions in the X groups of bit positions and a quantity of second bit positions are determined. The foregoing process of dividing the bit positions of the first sequence or the interleaved first sequence into the X groups of bit positions may also be described as a process of dividing the A second bit positions into the X groups of bit positions, or may be described as a process of dividing the A second bit positions into X groups of second bit positions.

The A second bit positions are distributed in at least two groups of bit positions in the X groups of bit positions.

For example, the X groups of bit positions are {1 0}, {15 14}, {13 11 7 12}, and {10 6 9 5 3 8 4 2 1 0}, and the A second bit positions are {15 14 13 11}. It may be determined that the first group of bit positions does not include the second bit positions, that is, a quantity of second bit positions included in the first group of bit positions is 0; the second group of bit positions includes second bit positions 15 and 14, that is, a quantity of second bit positions included in the second group of bit positions is 2; the third group of bit positions includes second bit positions 13 and 11, and a quantity of second bit positions included in the third group of bit positions is 2; and the fourth group of bit positions does not include the second bit positions, that is, a quantity of second bit positions included in the fourth group of bit positions is 0.

Step 804: The transmitter device divides A first bit positions in the K first bit positions into X groups of first bit positions.

In a first possible design, the A first bit positions are determined based on the K first bit positions and the K second bit positions.

For example, the transmitter device may determine K third bit positions based on the K first bit positions, and determine the A first bit positions based on A third bit positions in the K third bit positions.

A number of a third bit position corresponding to a first bit position numbered i is $i+N_2-N_1$, and $0 \leq i \leq N_1-1$. The A third bit positions are bit positions that are in the K third bit positions and whose numbers are different from those of the K second bit positions. A number of a first bit position corresponding to a third bit position numbered j is $j-(N_2-N_1)$, where $N_2-N_1 \leq j \leq N_2-1$.

Optionally, the K first bit positions may be denoted as $\bar{Q}_{I_1}^{N_1}$, the K second bit positions may be denoted as $\bar{Q}_{I_2}^{N_2}$, and a number i of each first bit position in $\bar{Q}_{I_1}^{N_1}$ may be added to $(N_2-N_1)$ to obtain the K third bit positions $\bar{Q}_{I_1}^{N_2}$. In this way, the A third bit positions may be denoted as ($\bar{Q}_{I_1}^{N_2}-\bar{Q}_{I_2}^{N_2}$) to represent bit positions that are in the K third bit positions and whose numbers are different from those of the K second bit positions. Further, $(N_2-N_1)$ may be subtracted from a number j of each third bit position in ($\bar{Q}_{I_1}^{N_2}-\bar{Q}_{I_2}^{N_2}$) to obtain the A first bit positions $\bar{Q}_{cp}^{u}$.

For example, K is 15, $N_1$ is 16, and $N_2$ is 32. Assuming that the K first bit positions $\bar{Q}_{I_1}^{N_1}$ are {15 14 13 11 7 12 10 6 9 5 3 8 4 2 1}, and the K second bit positions $\bar{Q}_{I_2}^{N_2}$ are {31 30 29 27 23 15 28 22 25 26 21 14 13 19 11}, 16 (that is, $N_2-N_1$) may be added to the number i of each first bit position in $\bar{Q}_{I_1}^{N_1}$ to obtain the K third bit positions $\bar{Q}_{I_1}^{N_2}=$ {31 30 29 27 23 28 26 22 25 21 19 24 20 18 17}, and further, bit positions {24 20 18 17} that are in the K third bit positions $\bar{Q}_{I_1}^{N_2}$ and whose numbers are different from those of the K second bit positions $\bar{Q}_{I_2}^{N_2}$ may be determined as the A third bit positions ($\bar{Q}_{I_1}^{N_2}-\bar{Q}_{I_2}^{N_2}$). Further, 16 (that is, $N_2-N_1$) may be subtracted from the number j of each third bit position in $(\bar{Q}_{I_1}^{N_2}-\bar{Q}_{I_2}^{N_2})=$ {24 20 18 17}, to obtain the A first bit positions $\bar{Q}_{cp}^{u}=$ {8 4 2 1}.

It should be noted that, in the first possible design, a manner of determining the A first bit positions is described by using an example in which definition starts from bit 0. It may be understood that when definition starts from bit 1, a number of a third bit position corresponding to a first bit position numbered i is $i+N_2-N_1$, where $1 \leq i \leq N_1$. A number of a first bit position corresponding to a third bit position numbered j is $j-(N_2-N_1)$, where $N_2-N_1+1 \leq j \leq N_2$.

In a second possible design, the A first bit positions are the last A bit positions sorted in descending order of reliability in the K first bit positions.

A quantity of bit positions whose numbers are less than $N_2-N_1$ in the K second bit positions may be determined as a specific value of A.

For example, K is 15, $N_1$ is 16, and $N_2$ is 32. Assuming that 15 (that is, K) second bit positions are {31 30 29 27 23 15 28 22 25 26 21 14 13 19 11}, it may be determined that a quantity of bit positions whose numbers are less than 16 (that is, $N_2-N_1$) in the 15 second bit positions is 4, that is, A is equal to 4.

For example, K is 15, A is 4, and determined 15 first bit positions are {15 14 13 11 7 12 10 6 9 5 3 8 4 2 1}. Assuming that the 15 first bit positions are 15, 14, 13, 11, 7, 12, 10, 6, 9, 5, 3, 8, 4, 2, and 1 in descending order of reliability, it may be determined that the A first bit positions are {8 4 2 1}.

It should be noted that, in the second possible design, the specific value of A is described by using an example in which definition starts from bit 0. It may be understood that when definition starts from bit 1, a quantity of bit positions whose numbers are less than or equal to $N_2-N_1$ in the K second bit positions may be determined as the specific value of A.

Based on the foregoing description of the A first bit positions, the A first bit positions $\bar{Q}_{cp}^{u}$ may be divided into X groups of first bit positions (for example, $\bar{Q}_{cp}^{u_1}$, $\bar{Q}_{cp}^{u_2}$, ..., and $\bar{Q}_{cp}^{u_X}$). A quantity of first bit positions included in an $x^{th}$ group of first bit positions is the same as a quantity of second bit positions included in the x$^{th}$ group of bit positions. When the quantity of second bit positions included in the x$^{th}$ group of bit positions is 0, the quantity of first bit positions included in the x$^{th}$ group of first bit positions is also 0.

In a first possible design, the transmitter device may group the A first bit positions based on reliability, to obtain the X groups of first bit positions.

For example, reliability of an (x+1)$^{th}$ group of first bit positions is higher than reliability of an x$^{th}$ group of first bit positions, where x=1, 2, ..., X. To be specific, $\bar{Q}_{cp}^{u_1}$ indicates the most unreliable $\left|\bar{Q}_{cp}^{u_1}\right|$ first bit positions in $\bar{Q}_{cp}^{u}$, $\bar{Q}_{cp}^{u_2}$ indicates the most unreliable $\left|\bar{Q}_{cp}^{u_2}\right|$ first bit positions in $\bar{Q}_{cp}^{u} - \bar{Q}_{cp}^{u_1}$, ..., and $\bar{Q}_{cp}^{u_X}$ indicates the most unreliable $\left|\bar{Q}_{cp}^{u_X}\right|$ first bit positions in $\bar{Q}_{cp}^{u} - \left(\bar{Q}_{cp}^{u_1} + \bar{Q}_{cp}^{u_2} + \ldots + \bar{Q}_{cp}^{u_{X-1}}\right)$.

For example, X=2, a quantity of second bit positions included in the first group of bit positions in the two groups of bit positions is 2, a quantity of second bit positions included in the second group of bit positions is also 2, and the A first bit positions $\bar{Q}_{cp}^{u}$ are sorted as {8 4 2 1} in descending order of reliability. The A first bit positions may be divided into the following two groups of first bit positions: $\bar{Q}_{cp}^{u_1}=$ {2 1} and $\bar{Q}_{cp}^{u_2}=$ {8 4}.

In another example, reliability of an (x+1)$^{th}$ group of first bit positions is lower than reliability of an x$^{th}$ group of first bit positions, where x=1, 2, ..., X. To be specific, $\bar{Q}_{cp}^{u_1}$ indicates the most reliable $\left|\bar{Q}_{cp}^{u_1}\right|$ first bit positions in $\bar{Q}_{cp}^{u}$, $\bar{Q}_{cp}^{u_2}$ indicates the most reliable $\left|\bar{Q}_{cp}^{u_2}\right|$ first bit positions in $\bar{Q}_{cp}^{u} - \bar{Q}_{cp}^{u_1}$, ..., and $\bar{Q}_{cp}^{u_X}$ indicates the most reliable $\left|\bar{Q}_{cp}^{u_X}\right|$ first bit positions in $\bar{Q}_{cp}^{u} - \left(\bar{Q}_{cp}^{u_1} + \bar{Q}_{cp}^{u_2} + \ldots + \bar{Q}_{cp}^{u_{X-1}}\right)$.

For example, X=2, a quantity of second bit positions included in the first group of bit positions in the two groups of bit positions is 2, a quantity of second bit positions included in the second group of bit positions is also 2, and the A first bit positions $\bar{Q}_{cp}^{u}$ are sorted as {8 4 2 1} in descending order of reliability. The A first bit positions may be divided into the following two groups of first bit positions: $\bar{Q}_{cp}^{u_1}=$ {8 4} and $\bar{Q}_{cp}^{u_2}=$ {2 1}.

In a second possible design, the transmitter device may alternatively group the A first bit positions in a natural order of numbers, to obtain the X groups of first bit positions.

For example, numbers of the (x+1)$^{th}$ group of first bit positions are greater than numbers of the x$^{th}$ group of first bit positions, where x=1, 2, ..., X. To be specific, $\bar{Q}_{cp}^{u_1}$ indicates $\left|\bar{Q}_{cp}^{u_1}\right|$ first bit positions with smallest numbers in $\bar{Q}_{cp}^{u}$, $\bar{Q}_{cp}^{u_2}$ indicates $\left|\bar{Q}_{cp}^{u_2}\right|$ first bit positions with smallest numbers in $\bar{Q}_{cp}^{u} - \bar{Q}_{cp}^{u_1}$, ..., and $\bar{Q}_{cp}^{u_X}$ indicates $\left|\bar{Q}_{cp}^{u_X}\right|$ first bit positions with smallest numbers in $\bar{Q}_{cp}^{u} - \left(\bar{Q}_{cp}^{u_1} + \bar{Q}_{cp}^{u_2} + \ldots + \bar{Q}_{cp}^{u_{X-1}}\right)$.

For example, X=2, a quantity of second bit positions included in the first group of bit positions in the two groups of bit positions is 2, a quantity of second bit positions included in the second group of bit positions is also 2, and the A first bit positions $\bar{Q}_{cp}^{u}$ are sorted as {1 2 4 8} in ascending order of numbers. The A first bit positions may be divided into the following two groups of first bit positions: $\bar{Q}_{cp}^{u_1}=$ {1 2} and $\bar{Q}_{cp}^{u_2}=$ {4 8}.

In another example, numbers of the (x+1)$^{th}$ group of first bit positions are less than numbers of the x$^{th}$ group of first bit positions, where x=1, 2, ..., X. To be specific, $\bar{Q}_{cp}^{u_1}$ indicates $\left|\bar{Q}_{cp}^{u_1}\right|$ first bit positions with largest numbers in $\bar{Q}_{cp}^{u}$, $\bar{Q}_{cp}^{u_2}$ indicates $\left|\bar{Q}_{cp}^{u_2}\right|$ first bit positions with largest numbers in $\bar{Q}_{cp}^{u} - \bar{Q}_{cp}^{u_1}$, ..., and $\bar{Q}_{cp}^{u_X}$ indicates $\left|\bar{Q}_{cp}^{u_X}\right|$ first bit positions with largest numbers in $\bar{Q}_{cp}^{u} - \left(\bar{Q}_{cp}^{u_1} + \bar{Q}_{cp}^{u_2} + \ldots + \bar{Q}_{cp}^{u_{X-1}}\right)$.

For example, X=2, a quantity of second bit positions included in the first group of bit positions in the two groups of bit positions is 2, a quantity of second bit positions included in the second group of bit positions is also 2, and the A first bit positions $\bar{Q}_{cp}^{u}$ are sorted as {8 4 2 1} in descending order of numbers (or from high to low of numbers). The A first bit positions may be divided into the following two groups of first bit positions: $\bar{Q}_{cp}^{u_1}=$ {8 4} and $\bar{Q}_{cp}^{u_2}=$ {2 1}.

In a third possible design, the transmitter device may alternatively interleave the A first bit positions based on a fourth interleaving pattern, and divide A interleaved first bit positions into the X groups of first bit positions.

Optionally, the fourth interleaving pattern may be one or more of the following: a random interleaving pattern, a triangular interleaving pattern, a row-column interleaving pattern, a reverse-order interleaving pattern, or the like. This is not limited.

Optionally, the A interleaved first bit positions may be grouped in a front-to-back order. To be specific, $\bar{Q}_{cp}^{u_1}$ indicates $\left|\bar{Q}_{cp}^{u_1}\right|$ foremost first bit positions in the A interleaved first bit positions, $\bar{Q}_{cp}^{u_2}$ indicates $\left|\bar{Q}_{cp}^{u_2}\right|$ foremost first bit positions other than $\bar{Q}_{cp}^{u_1}$ in the A interleaved first bit positions, ..., and $\bar{Q}_{cp}^{u_X}$ indicates $\left|\bar{Q}_{cp}^{u_X}\right|$ foremost first bit positions other than ( $\bar{Q}_{cp}^{u_1} + \bar{Q}_{cp}^{u_2} + \ldots + \bar{Q}_{cp}^{u_{X-1}}$ ) in the A interleaved first bit positions. Alternatively, the A interleaved first bit positions may be grouped in a back-to-front order. To be specific, $\bar{Q}_{cp}^{u_1}$ indicates $\left|\bar{Q}_{cp}^{u_1}\right|$ rearmost first bit positions in the A interleaved first bit positions, $\bar{Q}_{cp}^{u_2}$ indicates $\left|\bar{Q}_{cp}^{u_2}\right|$ rearmost first bit positions other than $\bar{Q}_{cp}^{u_1}$ in the A interleaved first bit positions, ..., and $\bar{Q}_{cp}^{u_X}$ indicates $\left|\bar{Q}_{cp}^{u_X}\right|$ rearmost first bit positions other than ( $\bar{Q}_{cp}^{u_1} + \bar{Q}_{cp}^{u_2} + \ldots + \bar{Q}_{cp}^{u_{X-1}}$ ) in the A interleaved first bit positions.

For example, interleaving may be performed based on the fourth interleaving pattern at a granularity of bit position, to obtain the A interleaved first bit positions, and the A interleaved first bit positions are divided into the X groups of first bit positions.

For example, X=2, a quantity of second bit positions included in the first group of bit positions in the two groups of bit positions is 2, a quantity of second bit positions included in the second group of bit positions is also 2, and the A first bit positions $\bar{Q}_{cp}^{u}$ are {8 4 2 1}. The A first bit positions may be interleaved based on a fourth interleaving pattern at a granularity of bit position. Assuming that A interleaved first bit positions are {2 8 1 4}, the A interleaved first bit positions may be divided into the following two groups of first bit positions in a front-to-back order: $\bar{Q}_{cp}^{u_1} = \{2\ 8\}$ and $\bar{Q}_{cp}^{u_2} = \{1\ 4\}$ .

In another example, interleaving may be performed based on the fourth interleaving pattern at a granularity of sub-block. To be specific, the A first bit positions may be divided into B sub-blocks, the B sub-blocks are interleaved, to obtain A interleaved first bit positions, and the A interleaved first bit positions are divided into the X groups of first bit positions.

Each sub-block may include one or more first bit positions. The A first bit positions may be divided into B sub-blocks based on reliability (for example, in descending order or in ascending order), or the A first bit positions may be divided into B sub-blocks based on a natural order of numbers (for example, in descending order or in ascending order). This is not limited.

For example, X=2, a quantity of second bit positions included in the first group of bit positions in the two groups of bit positions is 2, a quantity of second bit positions included in the second group of bit positions is also 2, the A first bit positions $\bar{Q}_{cp}^{u}$ are {8 4 2 1}, and B=2. The A first bit positions may be divided into the following two sub-blocks in a natural order of numbers: a sub-block 1={8 4} and a sub-block 2={2 1}. Further, the two sub-blocks may be interleaved based on the fourth interleaving pattern at a granularity of sub-block. Assuming that the A interleaved first bit positions are {2 1 8 4}, the A interleaved first bit positions may be divided into the following two groups of first bit positions in a front-to-back order: $\bar{Q}_{cp}^{u_1} = \{2\ 1\}$ and $\bar{Q}_{cp}^{u_2} = \{8\ 4\}$ .

Step 805: The transmitter device maps, based on an information bit sequence having a length of K, information bits corresponding to the x$^{th}$ group of first bit positions to the second bit positions in the x$^{th}$ group of bit positions of the first sequence, to obtain a second sequence.

The transmitter device may map an information bit sequence having a length of K to the K first bit positions of a third sequence having a length of $N_1$, to obtain a fourth sequence, and determine, based on information bits corresponding to the A first bit positions in the K first bit positions, A information bits corresponding to the X groups of first bit positions, or determine an information bit corresponding to each first bit position in the X groups of first bit positions, or determine information bits corresponding to each group of first bit positions in the X groups of first bit positions.

The transmitter device may select the first K bit positions of the third sequence as the K first bit positions (the K first bit positions are information bit positions) in descending order of reliability based on the reliability sequence having a length of $N_1$, map the information bit sequence having a length of K to the K first bit positions, that is, map the information bit sequence to the K information bit positions of the third sequence, and set values of remaining $N_1$-K bit positions of the third sequence to 0, to obtain the fourth sequence.

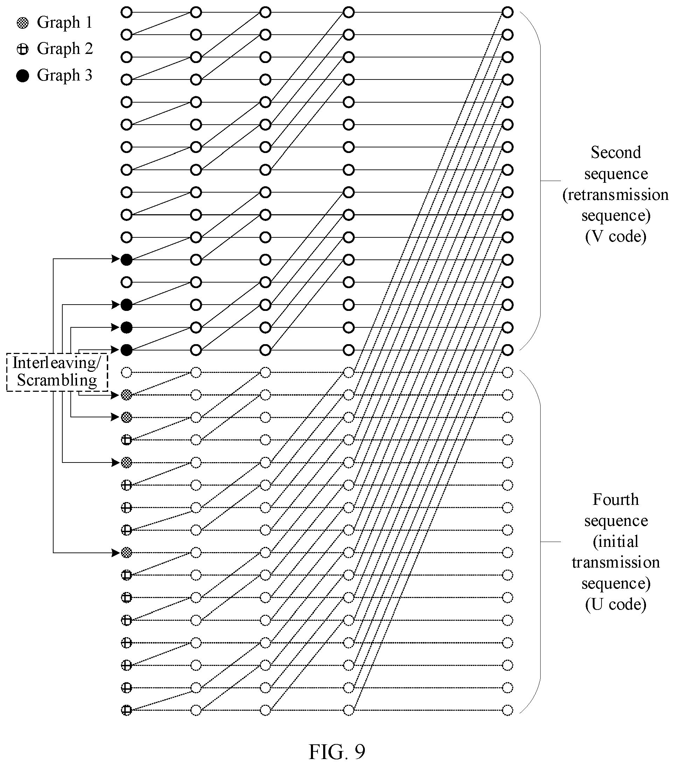

For example, the reliability sequence is the reliability sequence having a length of 16 shown in Table 1, and a length of the third sequence is 16. When the length of the information bit sequence is 15, it may be determined, based on the reliability sequence shown in Table 1, that the K first bit positions in descending order of reliability in the third sequence are {15 14 13 11 7 12 10 6 9 5 3 8 4 2 1}. To be specific, as shown in FIG. 9, it may be determined that the information bit positions are {15 14 13 11 7 12 10 6 9 5 3 8 4 2 1} (that is, bit positions filled with a graph 1 and a graph 2 in FIG. 9). The information bit sequence having a length of 15 may be mapped to the 15 information bit positions of the third sequence, and a value of the remaining 1 bit position (that is, a bit position filled with no graph in FIG. 9) of the third sequence is set to 0, to obtain the fourth sequence.

Based on the foregoing descriptions of the A first bit positions and the X groups of first bit positions, the transmitter device may determine, based on the fourth sequence, the information bits corresponding to the A first bit positions included in the X groups of first bit positions.

For example, as shown in FIG. 9, for example, the A first bit positions are {8 4 2 1} (that is, bit positions filled with the graph 1 in FIG. 9), the transmitter device may determine information bits at bit positions 8, 4, 2, and 1 in the fourth sequence as the information bits corresponding to the A first bit positions, that is, as the information bits corresponding to the X groups of first bit positions.

Optionally, the transmitter device may further perform polar coding on the fourth sequence to obtain the initial transmission sequence.

Based on the foregoing description, the transmitter device may use the second bit positions in the $x^{th}$ group of bit positions in the first sequence as information bit positions, and map the information bits corresponding to the $x^{th}$ group of first bit positions to the second bit positions in the $x^{th}$ group of bit positions in the first sequence, where x=1, 2, ..., X. The transmitter device may further set values of $N_2-N_1-A$ bit positions other than the second bit positions in the X groups of bit positions in the first sequence to 0, to obtain the second sequence.

For example, as shown in FIG. 9, $N_1$ is 16, $N_2$ is 32, the X groups of first bit positions are respectively $\bar{Q}_{cp}^{u_1}=\{8\ 4\}$ and $\bar{Q}_{cp}^{u_2}=\{2\ 1\}$, and the second bit positions in the X groups of bit positions are respectively $\bar{Q}_{cp}^{v_1}=\{11\ 13\}$ and $\bar{Q}_{cp}^{v_2}=\{14\ 15\}$. The transmitter device may map information bits at bit positions 8 and 4 of a fourth sequence having a length of 16 to bit positions 11 and 13 of a first sequence having a length of 16; and map information bits at bit positions 2 and 1 of the fourth sequence to bit positions 14 and 15 of the first sequence, and set values of remaining 12 bit positions in the first sequence to 0, to obtain the second sequence.

Optionally, the transmitter device may map, in an interleaving manner based on a first interleaving pattern, the information bits corresponding to the $x^{th}$ group of first bit positions to the second bit positions in the $x^{th}$ group of bit positions.

In a first possible design, the transmitter device may map, in an interleaving manner based on the first interleaving pattern and by using a reverse-order mapping relationship, the information bits corresponding to the $x^{th}$ group of first bit positions to the second bit positions in the $x^{th}$ group of bit positions.

For example, the transmitter device may map, in an interleaving manner based on the first interleaving pattern and by using a reverse-order mapping relationship, information bits corresponding to first bit positions sorted in ascending order of numbers in the $x^{th}$ group of first bit positions to second bit positions sorted in descending order of numbers in the $x^{th}$ group of bit positions.

For example, as shown in FIG. 9, $N_1$ is 16, $N_2$ is 32, the X groups of first bit positions are respectively $\bar{Q}_{cp}^{u_1}=\{8\ 4\}$ and $\bar{Q}_{cp}^{u_2}=\{2\ 1\}$, and the second bit positions in the X groups of bit positions are respectively $\bar{Q}_{cp}^{v_1}=\{11\ 13\}$ and $\bar{Q}_{cp}^{v_2}=\{14\ 15\}$. The transmitter device may map, in an interleaving manner based on the first interleaving pattern, information bits at bit positions 4 and 8 of a fourth sequence having a length of 16 to bit positions 13 and 11 of a first sequence having a length of 16; and map information bits at bit positions 1 and 2 of the fourth sequence to bit positions 15 and 14 of the first sequence, and set values of remaining 12 bit positions in the first sequence to 0, to obtain the second sequence.

In a second possible design, the transmitter device may alternatively interleave the $x^{th}$ group of first bit positions based on the first interleaving pattern, and map information bits corresponding to an $x^{th}$ group of interleaved first bit positions to the second bit positions in the $x^{th}$ group of bit positions in a specific order (for example, in a front-to-back order or in a back-to-front order).

For example, the transmitter device may interleave the $x^{th}$ group of first bit positions based on the first interleaving pattern at a granularity of bit position, to obtain the $x^{th}$ group of interleaved first bit positions, and map the information bits corresponding to the $x^{th}$ group of interleaved first bit positions to the second bit positions in the $x^{th}$ group of bit positions in a specific order.

In another example, the transmitter device may alternatively interleave the $x^{th}$ group of first bit positions based on the first interleaving pattern at a granularity of sub-block, to be specific, divide the $x^{th}$ group of first bit positions into a plurality of sub-blocks, interleave the plurality of sub-blocks, to obtain the $x^{th}$ group of interleaved first bit positions, and map the information bits corresponding to the $x^{th}$ group of first bit positions to the second bit positions in the $x^{th}$ group of bit positions in a specific order.

Each sub-block may include one or more first bit positions. The $x^{th}$ group of first bit positions may be divided into a plurality of sub-blocks based on reliability (for example, in descending order or in ascending order), or the $x^{th}$ group of first bit positions may be divided into a plurality of sub-blocks based on a natural order of numbers (for example, in descending order or in ascending order). This is not limited.

In a third possible design, similar to the foregoing case in which the transmitter device divides the A first bit positions and the A second bit positions into the X groups of first bit positions and the X groups of bit positions respectively during bit mapping, and performs mapping based on the bit position groups, when mapping the information bits corresponding to the $x^{th}$ group of first bit positions to the second bit positions in the $x^{th}$ group of bit positions, the transmitter device may alternatively divide the $x^{th}$ group of first bit positions and the second bit positions in the $x^{th}$ group of bit positions into a plurality of sub-blocks separately, and perform bit mapping based on the sub-blocks and the first interleaving pattern, to be specific, may map an information bit corresponding to a first sub-block in the $x^{th}$ group of first bit positions to a first sub-block in the second bit positions in the $x^{th}$ group of bit positions in an interleaving manner, ..., and map an information bit corresponding to a last sub-block in the $x^{th}$ group of first bit positions to a last sub-block in the second bit positions in the $x^{th}$ group of bit positions in an interleaving manner.

For descriptions of dividing the $x^{th}$ group of first bit positions and the second bit positions in the $x^{th}$ group of bit positions into the plurality of sub-blocks, refer to the descriptions in the second possible design. Details are not described again.

Based on the foregoing three possible designs, for example, the first interleaving pattern may be one or more of the following: a random interleaving pattern, a triangular interleaving pattern, a row-column interleaving pattern, a reverse-order interleaving pattern, or the like. This is not limited.

Optionally, different from the foregoing interleaving, the transmitter device may scramble the information bits corresponding to the X groups of first bit positions, and map the scrambled information bits corresponding to the X groups of first bit positions to the second bit positions in the X groups of bit positions of the first sequence, to obtain the second sequence.

Step 806: The transmitter device performs polar coding on the second sequence to obtain an encoded bit sequence.

In a first possible design, when performing polar coding on the second sequence, the transmitter device may perform exclusive OR processing on the second sequence and the fourth sequence, to obtain an XOR-processed sequence, and perform polar coding on the XOR-processed sequence, to obtain a retransmission sequence.

In a second possible design, when performing polar coding on the second sequence, the transmitter device may alternatively perform polar coding on the second sequence to obtain a first polarization sequence, perform polar coding on the fourth sequence to obtain a second polarization sequence, and perform exclusive OR processing on the first polarization sequence and the second polarization sequence to obtain a retransmission sequence.

It may be understood that in a HARQ transmission scenario, the encoded bit sequence may also be referred to as a retransmission sequence.

Step 807: The transmitter device sends one or more bits in the encoded bit sequence to a receiver device; and correspondingly, the receiver device receives a symbol sequence from the transmitter device.

When one or more bits in the encoded bit sequence sent by the transmitter device to the receiver device are transmitted by using a channel, the one or more bits may be affected by interference such as noise. The symbol sequence received by the receiver device is one or more bits that are in the encoded bit sequence and that are affected by interference such as noise.

Optionally, the transmitter device may send an initial transmission sequence (for example, a sequence obtained after polar coding is performed on the fourth sequence) to the receiver device with reference to the foregoing description of HARQ transmission. The receiver device attempts to decode a received symbol sequence (the symbol sequence is a symbol sequence corresponding to the initial transmission sequence). If decoding succeeds, the receiver device may feed back an acknowledgment frame to the transmitter device, and the transmitter device may stop sending based on the acknowledgment frame. If the receiver side fails to decode the symbol sequence, the receiver device may buffer the received symbol sequence, and feed back a negative acknowledgment frame to the transmitter device, or may not feed back a negative acknowledgment frame to the transmitter device. When the transmitter device receives a negative acknowledgment frame or does not receive an acknowledgment frame within specific duration, the transmitter device may continue to send one or more bits in the encoded bit sequence as incremental redundancy. The receiver device may decode the received symbol sequence corresponding to the initial transmission sequence and a symbol sequence corresponding to the one or more bits in the encoded bit sequence together.

Step 808: The receiver device determines K first bit positions based on a reliability sequence having a length of $N_1$, and determines K second bit positions based on a reliability sequence having a length of $N_2$.

The receiver device may determine the K first bit positions and the K second bit positions with reference to step 801 and step 802 by using a method the same as that of the transmitter device. Details are not described again.

Step 809: The receiver device divides bit positions of a first sequence having a length of ($N_2$-$N_1$) into X groups of bit positions, and divides A first bit positions in the K first bit positions into X groups of first bit positions.

Step 810: The receiver device decodes the symbol sequence based on the X groups of first bit positions and second bit positions in the X groups of bit positions.

The receiver device may determine the X groups of first bit positions and the second bit positions in the X groups of bit positions with reference to step 803 and step 804 by using a method the same as that of the transmitter device, to decode the symbol sequence.

Optionally, when decoding the symbol sequence, the receiver device may decode, based on the X groups of first bit positions and the second bit positions in the X groups of bit positions, the received symbol sequence corresponding to the initial transmission sequence and the symbol sequence corresponding to the one or more bits in the encoded bit sequence together.

When decoding the symbol sequence, the receiver device may determine, based on the second bit positions in the determined X groups of bit positions, information bits at the second bit positions in the symbol sequence. When encoding the information bit sequence, the transmitter device maps the A information bits in the information bit sequence having a length of K to both the X groups of first bit positions and the second bit positions in the X groups of bit positions, and there is a corresponding check relationship between the X groups of first bit positions and the second bit positions in the X groups of bit positions. In this way, the receiver device may determine, based on the check relationship and the information bits at the second bit positions in the X groups of bit positions, information bits at the X groups of first bit positions in the symbol sequence, to implement decoding.

Based on the method shown in FIG. 8, some information bits (for example, the A information bits) of the information bit sequence having a length of K may be mapped to both the A first bit positions of the fourth sequence corresponding to the initial transmission sequence and the A second bit positions of the second sequence corresponding to the retransmission sequence. In other words, there is a corresponding check relationship between the A first bit positions of the fourth sequence and the A second bit positions of the second sequence. This can reduce decoding complexity and improve decoding performance. In addition, during bit mapping in this application, hierarchical mapping may be further performed. To be specific, A first bit positions are divided into X groups of first bit positions, and bit positions of a first sequence are divided into X groups of bit positions. In this way, a transmitter device may map information bits corresponding to an $x^{th}$ group of first bit positions to second bit positions in an $x^{th}$ group of bit positions of the first sequence, to implement hierarchical mapping. In addition, there is a corresponding check relationship between the $x^{th}$ group of first bit positions and the $x^{th}$ group of second bit positions. Therefore, decoding complexity can be reduced, performance of a small quantity of retransmission and a large quantity of retransmission can be balanced, and decoding performance can be improved. In addition, when decoding the symbol sequence, the receiver device may determine the X groups of first bit positions and the second bit positions in the X groups of bit positions in a manner the same as that of the transmitter device, to perform decoding based on the check relationship between the X groups of first bit positions and the second bit positions in the X groups of bit positions, thereby reducing decoding complexity and improving decoding performance.

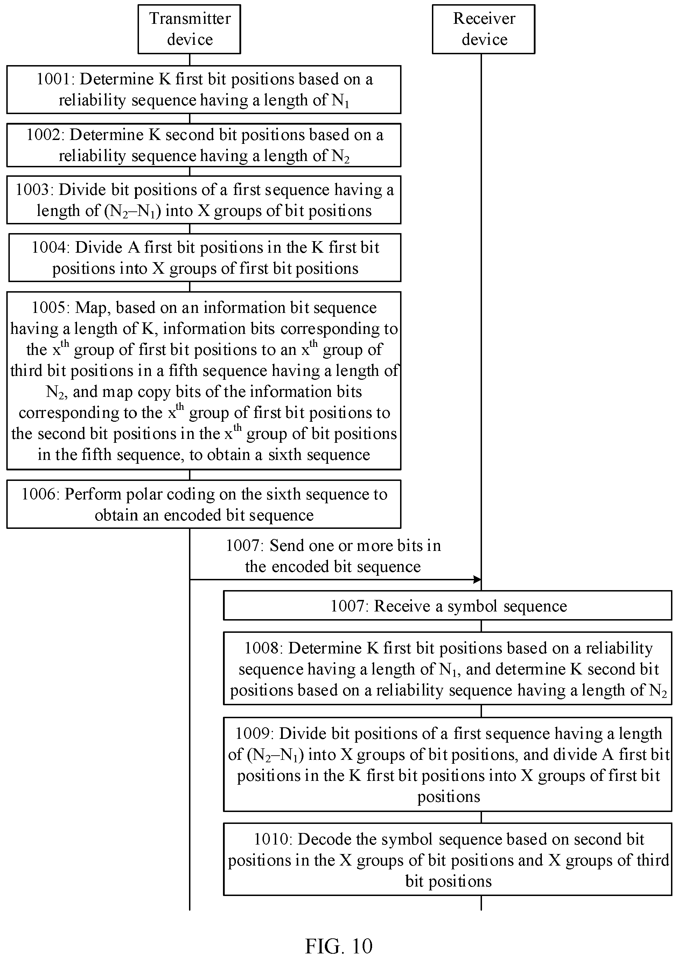

A polar code supporting self-decoding is used as an example below. Refer to FIG. 10. A communication method provided in an embodiment of this application is described. As shown in FIG. 10, the method may include the following steps:

Step 1001: A transmitter device determines K first bit positions based on a reliability sequence having a length of $N_1$.

For a description of step 1001, refer to the related description of step 801. Details are not described herein again.

Step 1002: The transmitter device determines K second bit positions based on a reliability sequence having a length of $N_2$.

For a description of step 1002, refer to the related description of step 802. Details are not described herein again.

Step 1003: The transmitter device divides bit positions of a first sequence having a length of ($N_2$-$N_1$) into X groups of bit positions.

The X groups of bit positions include A second bit positions in the K second bit positions, and X>2.

For a description of step 1003, refer to the related description of step 803. Details are not described herein again.

Step 1004: The transmitter device divides A first bit positions in the K first bit positions into X groups of first bit positions.

A quantity of first bit positions included in an $x^{th}$ group of first bit positions is the same as a quantity of second bit positions included in an $x^{th}$ group of bit positions, where x=1, 2, ..., X.

For a description of step 1004, refer to the related description of step 804. Details are not described herein again.

Step 1005: The transmitter device maps, based on an information bit sequence having a length of K, information bits corresponding to the $x^{th}$ group of first bit positions to an $x^{th}$ group of third bit positions in a fifth sequence having a length of $N_2$, and maps copy bits of the information bits corresponding to the $x^{th}$ group of first bit positions to the second bit positions in the $x^{th}$ group of bit positions in the fifth sequence, to obtain a sixth sequence.

The $x^{th}$ group of third bit positions corresponds to the $x^{th}$ group of first bit positions. For example, a number of a third bit position corresponding to a first bit position numbered i is $i+N_2-N_1$, and $0 \leq i \leq N_1-1$.

The transmitter device may use the $x^{th}$ group of third bit positions in the fifth sequence as information bit positions, and map the information bits corresponding to the $x^{th}$ group of first bit positions to the $x^{th}$ group of third bit positions in the fifth sequence, where x=1, 2, ..., X. The transmitter device may further use the second bit positions in the $x^{th}$ group of bit positions in the fifth sequence as information bit positions, and map copy bits of the information bits corresponding to the $x^{th}$ group of first bit positions to the second bit positions in the $x^{th}$ group of bit positions in the fifth sequence, where x=1, 2, ..., X.

Optionally, the transmitter device may alternatively map K-A information bits other than the A information bits in the information bit sequence (or may be described as information bits corresponding to K-A first bit positions other than the A first bit positions in the K first bit positions) to K-A second bit positions other than the A second bit positions in the K second bit positions of the fifth sequence.

Optionally, the transmitter device may alternatively set values of $N_2$-K-A bit positions other than the second bit positions in the X groups of bit positions, the X groups of third bit positions, and the K-A second bit positions in the fifth sequence to 0, to obtain the sixth sequence.

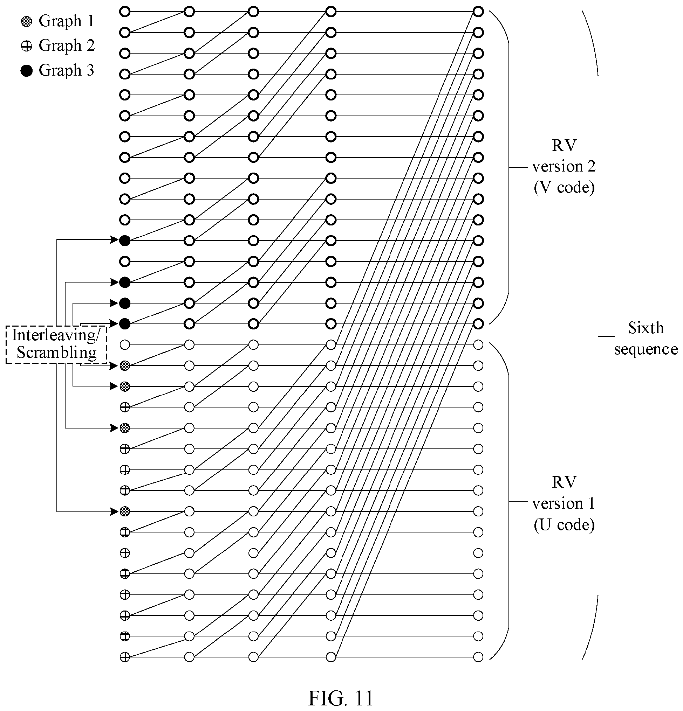

For example, K is 15, $N_1$ is 16, $N_2$ is 32, the X groups of first bit positions are respectively $\overline{Q}_{cp}^{u_1}=\{8\ 4\}$ and $\overline{Q}_{cp}^{u_2}=\{2\ 1\}$, the second bit positions in the X groups of bit positions are respectively $\overline{Q}_{cp}^{v_1}=\{13\ 11\}$ and $\overline{Q}_{cp}^{v_2}=\{15\ 14\}$, and the K-A second bit positions are {31 30 29 27 23 28 22 25 26 21 19}. The transmitter device may determine the X groups of third bit positions as {24 20} and {18 17} respectively. Based on this, as shown in bit positions filled with the graph 1 in FIG. 11, the transmitter device may map information bits at bit positions 8 and 4 of a fourth sequence having a length of 16 to bit positions 24 and 20 of a fifth sequence having a length of 32; and map information bits at bit positions 2 and 1 of the fourth sequence to bit positions 18 and 17 of the fifth sequence.

As shown in bit positions filled with a graph 3 in FIG. 11, the transmitter device may further map copy bits of the information bits at bit positions 8 and 4 of the fourth sequence to bit positions 11 and 13 of the fifth sequence; and map copy bits of information bits at bit positions 2 and 1 of the fourth sequence to bit positions 14 and 15 of the fifth sequence.

As shown in bit positions filled with a graph 2 in FIG. 11, the transmitter device may further map 11 information bits other than the information bits at bit positions 8, 4, 2, and 1 of the fourth sequence to bit positions 31, 30, 29, 27, 23, 28, 22, 25, 26, 21, and 19 of the fifth sequence. The transmitter device may further set values of remaining 13 bit positions in the fifth sequence to 0, to obtain the sixth sequence.

Optionally, the transmitter device may map, in an interleaving manner based on a second interleaving pattern, the information bits corresponding to the $x^{th}$ group of first bit positions to the $x^{th}$ group of third bit positions.

In a first possible design, the transmitter device may map, in an interleaving manner based on the second interleaving pattern and by using a reverse-order mapping relationship, the information bits corresponding to the $x^{th}$ group of first bit positions to the $x^{th}$ group of third bit positions.

For example, the transmitter device may map, in an interleaving manner based on the second interleaving pattern and by using a reverse-order mapping relationship, information bits corresponding to first bit positions sorted in ascending order of numbers in the $x^{th}$ group of first bit positions to third bit positions sorted in descending order of numbers in the $x^{th}$ group of third bit positions.

In a second possible design, the transmitter device may alternatively interleave the $x^{th}$ group of first bit positions based on the second interleaving pattern, and map information bits corresponding to an $x^{th}$ group of interleaved first bit positions to the $x^{th}$ group of third bit positions in a specific order (for example, in a front-to-back order or in a back-to-front order).

For example, the transmitter device may interleave the $x^{th}$ group of first bit positions based on the second interleaving pattern at a granularity of bit position, to obtain the $x^{th}$ group of interleaved first bit positions, and map the information bits corresponding to the $x^{th}$ group of interleaved first bit positions to the $x^{th}$ group of third bit positions in a specific order.

In another example, the transmitter device may alternatively interleave the $x^{th}$ group of first bit positions based on the second interleaving pattern at a granularity of sub-block, to be specific, divide the $x^{th}$ group of first bit positions into a plurality of sub-blocks, interleave the plurality of sub-blocks, to obtain the $x^{th}$ group of interleaved first bit positions, and map the information bits corresponding to the $x^{th}$ group of first bit positions to the $x^{th}$ group of third bit positions in a specific order.

In a third possible design, similar to the foregoing case in which the transmitter device divides the A first bit positions and the A third bit positions into the X groups of first bit positions and the X groups of third bit positions respectively during bit mapping, and performs mapping based on the bit position groups, when mapping the information bits corresponding to the $x^{th}$ group of first bit positions to the $x^{th}$ group of third bit positions, the transmitter device may alternatively divide the $x^{th}$ group of first bit positions and the $x^{th}$ group of third bit positions into a plurality of sub-blocks separately, and perform bit mapping based on the sub-blocks and the second interleaving pattern, to be specific, may map an information bit corresponding to a first sub-block in the $x^{th}$ group of first bit positions to a first sub-block in the $x^{th}$ group of third bit positions in an interleaving manner, ..., and map an information bit corresponding to a last sub-block in the $x^{th}$ group of first bit positions to a last sub-block in the $x^{th}$ group of third bit positions in an interleaving manner.

Optionally, the transmitter device may alternatively map, in an interleaving manner based on the second interleaving pattern, copy bits of the information bits corresponding to the $x^{th}$ group of first bit positions to the second bit positions in the $x^{th}$ group of bit positions.

For a description of the optional solution, refer to the related description in step 805 that the transmitter device maps, in an interleaving manner, the information bits corresponding to the $x^{th}$ group of first bit positions to the second bit positions in the $x^{th}$ group of bit positions. Details are not described herein again.

Optionally, the transmitter device may alternatively map, in an interleaving manner based on the second interleaving pattern, information bits corresponding to K-A first bit positions other than the A first bit positions in the K second bit positions to K-A second bit positions other than the A second bit positions in the K second bit positions of the fifth sequence.

In a first possible design, the transmitter device may map, in an interleaving manner based on the second interleaving pattern by using a reverse-order mapping relationship, the information bits corresponding to the K-A first bit positions to the K-A second bit positions.

For example, the transmitter device may map, in an interleaving manner based on the first interleaving pattern and by using a reverse-order mapping relationship, information bits corresponding to first bit positions sorted in ascending order of numbers in the K-A first bit positions to second bit positions sorted in descending order of numbers in the K-A second bit positions.

In a second possible design, the transmitter device may alternatively interleave the K-A first bit positions based on the second interleaving pattern, and map information bits corresponding to K-A interleaved first bit positions to the K-A second bit positions in a specific order (for example, in a front-to-back order or in a back-to-front order).

For example, the transmitter device may interleave the K-A first bit positions based on the second interleaving pattern at a granularity of bit position, to obtain the K-A interleaved first bit positions, and map the information bits corresponding to the K-A interleaved first bit positions to the K-A second bit positions in a specific order.

In another example, the transmitter device may alternatively interleave the K-A first bit positions based on the second interleaving pattern at a granularity of sub-block, to be specific, divide the K-A first bit positions into a plurality of sub-blocks, interleave the plurality of sub-blocks, to obtain the K-A interleaved first bit positions, and map the information bits corresponding to the K-A first bit positions to the K-A second bit positions in a specific order.

In a third possible design, similar to the foregoing case in which the transmitter device divides the A first bit positions and the A second bit positions into the X groups of first bit positions and the X groups of second bit positions respectively during bit mapping, and performs mapping based on the bit position groups, when mapping the information bits corresponding to the K-A first bit positions to the K-A second bit positions, the transmitter device may alternatively divide the K-A first bit positions and the K-A second bit positions into a plurality of sub-blocks separately, and perform bit mapping based on the sub-blocks and the second interleaving pattern, to be specific, may map an information bit corresponding to a first sub-block in the K-A first bit positions to a first sub-block in the K-A second bit positions in an interleaving manner, ..., and map an information bit corresponding to a last sub-block in the K-A first bit positions to a last sub-block in the K-A second bit positions in an interleaving manner.

Based on the foregoing description of the second interleaving pattern, for example, the second interleaving pattern may be one or more of the following: a random interleaving pattern, a triangular interleaving pattern, a row-column interleaving pattern, a reverse-order interleaving pattern, or the like. This is not limited.

Optionally, different from the foregoing interleaving, the transmitter device may scramble the information bits corresponding to the X groups of first bit positions, map scrambled information bits corresponding to the X groups of first bit positions to the X groups of third bit positions of the fifth sequence, scramble copy bits of the information bits corresponding to the X groups of first bit positions, and map scrambled copy bits to the second bit positions in the X groups of bit positions of the fifth sequence.

Optionally, the transmitter device may scramble the information bits corresponding to the K-A first bit positions, and map scrambled information bits to the K-A second bit positions.

It may be understood that, in the foregoing interleaving or scrambling processing process, interleaving or scrambling processing may be performed on any one of the information bits corresponding to the X groups of first bit positions, the copy bits of the information bits corresponding to the X groups of first bit positions, and the information bits corresponding to the K-A first bit positions, or interleaving or scrambling processing may be performed on any two thereof, or interleaving or scrambling processing may be performed on all thereof. This is not limited.

Step 1006: The transmitter device performs polar coding on the sixth sequence to obtain an encoded bit sequence.

The sixth sequence having a length of $N_2$ may include two RV versions. Each RV version may be independently decoded, or the two RV versions may be combined into a long code to enhance decoding. The transmitter device may perform polar coding on the sixth sequence including the two RV versions, to obtain the encoded bit sequence.

For example, as shown in FIG. 11, the sixth sequence having a length of 32 may include an RV version 1 having a length of 16 and an RV version 2 having a length of 16. Each RV version may be independently decoded, or the two RV versions may be combined into a long code to enhance decoding.

Step 1007: The transmitter device sends one or more bits in the encoded bit sequence to a receiver device; and correspondingly, the receiver device receives a symbol sequence from the transmitter device.

Step 1008: The receiver device determines K first bit positions based on a reliability sequence having a length of $N_1$, and determines K second bit positions based on a reliability sequence having a length of $N_2$.

The receiver device may determine the K first bit positions and the K second bit positions with reference to step 801 and step 802 by using a method the same as that of the transmitter device. Details are not described again.

Step 1009: The receiver device divides bit positions of a first sequence having a length of $(N_2-N_1)$ into X groups of bit positions, and divides A first bit positions in the K first bit positions into X groups of first bit positions.

Step 1010: The receiver device decodes the symbol sequence based on second bit positions in the X groups of bit positions and X groups of third bit positions.

The receiver device may determine the second bit positions in the X groups of bit positions and the X groups of third bit positions with reference to step 803 and step 804 by using a method the same as that of the transmitter device, to decode the symbol sequence based on the second bit positions in the X groups of bit positions and the X groups of third bit positions.

The receiver device may perform self-decoding based on the RV version 1 or the RV version 2 alone of the sixth sequence, or may combine the RV version 1 and the RV version 2 into a long code to enhance decoding.

For example, the receiver device may decode the RV version 1 in the received symbol sequence based on the second bit positions in the X groups of bit positions.

In another example, the receiver device may alternatively decode the RV version 2 in the received symbol sequence based on the X groups of third bit positions and the K-A second bit positions in the K second bit positions.

In still another example, the receiver device may alternatively combine the RV version 1 and the RV version 2 in the received symbol sequence into a long code, and decode the long code based on the second bit positions in the X groups of bit positions and the X groups of third bit positions.

When decoding the long code, the receiver device may determine, based on the second bit positions in the determined X groups of bit positions, information bits at the second bit positions in the long code. When encoding the information bit sequence, the transmitter device maps the A information bits in the information bit sequence having a length of K to both the X groups of third bit positions and the second bit positions in the X groups of bit positions, and there is a corresponding check relationship between the X groups of third bit positions and the second bit positions in the X groups of bit positions. In this way, the receiver device may determine, based on the check relationship and the information bits at the second bit positions in the X groups of bit positions, information bits at the X groups of third bit positions in the long code, to implement decoding.

Based on the method shown in FIG. 10, some information bits (for example, the A information bits) of the information bit sequence having a length of K may be mapped to both the A second bit positions of the RV version 1 and the A third bit positions of the RV version 2. In other words, there is a corresponding check relationship between information bits at the A second bit positions of the sixth sequence and information bits at the A third bit positions. This can reduce decoding complexity and improve decoding performance. In addition, during bit mapping in this application, hierarchical mapping may be further performed. To be specific, A first bit positions may be divided into X groups of first bit positions, bit positions of a first sequence may be divided into X groups of bit positions, and A third bit positions may be divided into X groups of third bit positions. In this way, the transmitter device may map the information bits corresponding to the $x^{th}$ group of first bit positions to the $x^{th}$ group of third bit positions of a fifth sequence, and map copy bits of the information bits corresponding to the $x^{th}$ group of first bit positions to the second bit positions in the $x^{th}$ group of bit positions of the fifth sequence, to implement hierarchical mapping, thereby reducing decoding complexity and improving decoding performance. In addition, when decoding the symbol sequence, the receiver device may determine the second bit positions in the X groups of bit positions and the X groups of third bit positions in a manner the same as that of the transmitter device, to perform decoding based on the check relationship between the second bit positions in the X groups of bit positions and the X groups of third bit positions, thereby reducing decoding complexity and improving decoding performance.

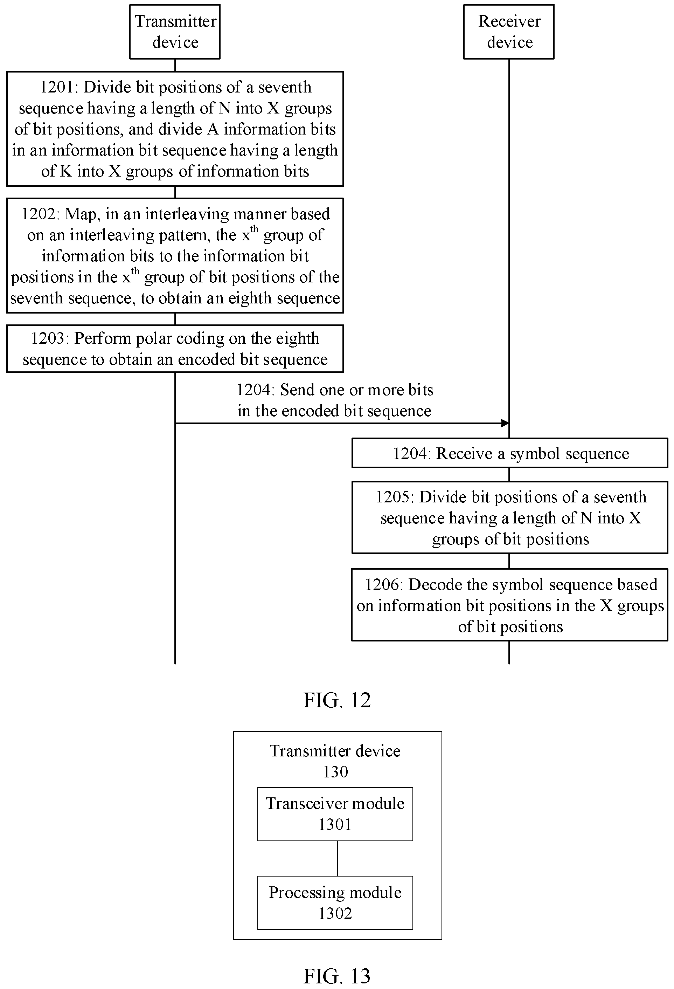

In addition, an embodiment of this application further provides an interleaving processing-based communication method. As shown in FIG. 12, the method may include the following steps:

Step 1201: A transmitter device divides bit positions of a seventh sequence having a length of N into X groups of bit positions, and divides A information bits in an information bit sequence having a length of K into X groups of information bits.

A quantity of information bits included in an $x^{th}$ group of bit positions is equal to a quantity of information bits included in an $x^{th}$ group of information bits, where x=1, 2, ..., X, and X>2.

Optionally, the transmitter device may perform sub-block interleaving on the seventh sequence, and divide bit positions of an interleaved seventh sequence into the X groups of bit positions.

Step 1202: The transmitter device maps, in an interleaving manner based on an interleaving pattern, the $x^{th}$ group of information bits to the information bit positions in the $x^{th}$ group of bit positions of the seventh sequence, to obtain an eighth sequence.

For example, the interleaving pattern may be one or more of the following: a random interleaving pattern, a triangular interleaving pattern, a row-column interleaving pattern, or a reverse-order interleaving pattern.

When encoding the information bit sequence, the transmitter device may perform interleaving processing based on the interleaving pattern, to reduce decoding complexity and improve decoding performance. In this application, when bit mapping is performed, a processing manner of grouping bit positions may be further used to implement hierarchical mapping, so that decoding complexity can be reduced, and decoding performance can be improved.

Step 1203: The transmitter device performs polar coding on the eighth sequence to obtain an encoded bit sequence.

Step 1204: The transmitter device sends one or more bits in the encoded bit sequence to a receiver device; and correspondingly, the receiver device receives a symbol sequence from the transmitter device.

Step 1205: The receiver device divides bit positions of a seventh sequence having a length of N into X groups of bit positions.

Step 1206: The receiver device decodes the symbol sequence based on information bit positions in the X groups of bit positions.

When encoding the information bit sequence, the transmitter device groups the A information bits in the information bit sequence, and maps the A information bits to the information bit positions in the X groups of bit positions in an interleaving manner based on the interleaving pattern. When decoding the symbol sequence, the receiver device may determine the information bit positions in the X groups of bit positions in a manner the same as that of the transmitter device, to decode the symbol sequence based on the interleaving pattern and the information bit positions in the X groups of bit positions, thereby reducing decoding complexity and improving decoding performance.

It should be noted that various embodiments of this application may be implemented separately, or may be implemented in combination. This is not limited. Unless otherwise stated or there is a logic conflict, terms and/or descriptions in different embodiments provided by this application are consistent and may be mutually referenced, and technical features in different embodiments may be combined based on an internal logical relationship thereof, to form a new embodiment.

It may be understood that an execution body may perform some or all of the steps in embodiments of this application. The steps or operations are merely examples. Embodiments of this application may further include performing other operations or variations of various operations. In addition, the steps may be performed in a sequence different from that presented in embodiments of this application, and not all the operations in embodiments of this application may be necessarily performed.

The solutions provided in embodiments of this application are mainly described above from a perspective of interaction between the devices. It may be understood that, to implement the foregoing functions, each device includes a corresponding hardware structure and/or a corresponding software module for performing each function. A person of ordinary skill in the art should easily be aware that, in combination with algorithms and steps in the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the devices may be divided into functional modules based on the foregoing method examples. For example, each functional module may be obtained through division based on each corresponding function, or two or more than two functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used.

When each functional module is obtained through division based on each corresponding function, FIG. 13 shows a transmitter device 130. The transmitter device 130 may perform actions performed by the transmitter device in the methods shown in FIG. 8 to FIG. 12. All related content of steps in the foregoing method embodiments may be referenced to function descriptions of corresponding functional modules. For technical effects that can be achieved, refer to the foregoing method embodiments. Details are not described herein again.

The transmitter device 130 may include a transceiver module 1301 and a processing module 1302. For example, the transmitter device 130 may be a communication device, or may be a chip used in the communication device, or another combined device or component that has a function of the foregoing transmitter device. When the transmitter device 130 is a communication device, the transceiver module 1301 may be a transceiver. The transceiver may include an antenna, a radio frequency circuit, and the like. The processing module 1302 may be a processor (or a processing circuit), for example, a baseband processor. The baseband processor may include one or more CPUs. When the transmitter device 130 is a component that has a function of the foregoing transmitter device, the transceiver module 1301 may be a radio frequency unit, and the processing module 1302 may be a processor (or a processing circuit), for example, a baseband processor. When the transmitter device 130 is a chip system, the transceiver module 1301 may be an input/output interface of a chip (for example, a baseband chip); and the processing module 1302 may be a processor (or a processing circuit) of the chip system, and may include one or more central processing units. It should be understood that the transceiver module 1301 in this embodiment of this application may be implemented by a transceiver or a transceiver-related circuit component, and the processing module 1302 may be implemented by a processor or a processor-related circuit component (or referred to as a processing circuit).

For example, the transceiver module 1301 may be configured to perform all sending and receiving operations performed by the transmitter device in embodiments shown in FIG. 8 to FIG. 12, and/or configured to support another process of the technology described in this specification. The processing module 1302 may be configured to perform all operations other than sending and receiving operations performed by the transmitter device in embodiments shown in FIG. 8 to FIG. 12, and/or configured to support another process of the technology described in this specification.

In a first possible example, the processing module 1302 may be configured to: determine K first bit positions based on a reliability sequence having a length of $N_1$, and determine K second bit positions based on a reliability sequence having a length of $N_2$, where $K \leq N_1 < N_2$; the processing module 1302 may be further configured to: divide bit positions of a first sequence having a length of $(N_2 - N_1)$ into X groups of bit positions, and divide A first bit positions in the K first bit positions into X groups of first bit positions, where the X groups of bit positions include A second bit positions in the K second bit positions, a quantity of first bit positions included in an $x^{th}$ group of first bit positions is the same as a quantity of second bit positions included in an $x^{th}$ group of bit positions, $X \geq 2$, and x=1, 2, ..., X; the processing module 1302 may be further configured to: map, based on an information bit sequence having a length of K, information bits corresponding to the $x^{th}$ group of first bit positions to the second bit positions in the $x^{th}$ group of bit positions of the first sequence, to obtain a second sequence, and perform polar coding on the second sequence to obtain an encoded bit sequence; and the transceiver module 1301 is configured to: send one or more bits in the encoded bit sequence to a receiver device.

In a possible design, the processing module 1302 may be further configured to map, in an interleaving manner based on a first interleaving pattern, the information bits corresponding to the $x^{th}$ group of first bit positions to the second bit positions in the $x^{th}$ group of bit positions.

In a possible design, the processing module 1302 may be further configured to map, in an interleaving manner based on the first interleaving pattern, information bits corresponding to first bit positions sorted in ascending order of numbers in the $x^{th}$ group of first bit positions to second bit positions sorted in descending order of numbers in the $x^{th}$ group of bit positions.

In a possible design, the processing module 1302 may be further configured to: map the information bit sequence to the K first bit positions of a third sequence having a length of $N_1$, to obtain a fourth sequence; and determine, based on information bits corresponding to the A first bit positions in the K first bit positions, information bits corresponding to the $x^{th}$ group of first bit positions.

In a possible design, the processing module 1302 may be further configured to: perform exclusive OR processing on the second sequence and the fourth sequence, to obtain an XOR-processed sequence, and perform polar coding on the XOR-processed sequence, to obtain an encoded bit sequence.

In a possible design, the processing module 1302 may be further configured to: perform polar coding on the second sequence to obtain a first polarization sequence, perform polar coding on the fourth sequence to obtain a second polarization sequence, and perform exclusive OR processing on the first polarization sequence and the second polarization sequence to obtain an encoded bit sequence.

In a second possible example, the processing module 1302 may be configured to: determine K first bit positions based on a reliability sequence having a length of $N_1$, and determine K second bit positions based on a reliability sequence having a length of $N_2$, where $K \leq N_1 < N_2$; the processing module 1302 may be further configured to: divide bit positions of a first sequence having a length of $(N_2 - N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and x=1, 2, ..., X; the processing module 1302 may be further configured to: map, based on an information bit sequence having a length of K, information bits corresponding to the $x^{th}$ group of first bit positions to an $x^{th}$ group of third bit positions in a fifth sequence having a length of $N_2$, and map copy bits of the information bits corresponding to the $x^{th}$ group of first bit positions to the second bit positions in the $x^{th}$ group of bit positions in the fifth sequence, to obtain a sixth sequence, and perform polar coding on the sixth sequence to obtain an encoded bit sequence; and the transceiver module 1301 is configured to: send one or more bits in the encoded bit sequence to a receiver device, where the $x^{th}$ group of third bit positions corresponds to the $x^{th}$ group of first bit positions.

In a possible design, the processing module 1302 may be further configured to: map, in an interleaving manner based on a second interleaving pattern, the information bits corresponding to the $x^{th}$ group of first bit positions to the $x^{th}$ group of third bit positions in the fifth sequence, and map, in an interleaving manner, the copy bits of the information bits corresponding to the $x^{th}$ group of first bit positions to the second bit positions in the $x^{th}$ group of bit positions in the fifth sequence.

In a possible design, the processing module 1302 may be further configured to: map the information bit sequence to the K first bit positions of a third sequence having a length of $N_1$, to obtain a fourth sequence; and determine, based on information bits corresponding to the A first bit positions in the K first bit positions, information bits corresponding to the $x^{th}$ group of first bit positions.

In a possible design, the processing module 1302 may be further configured to: map K-A information bits other than A information bits corresponding to the X groups of first bit positions in the information bit sequence to K-A second bit positions other than the A second bit positions in the K second bit positions of the fifth sequence.

Based on the first possible example and the second possible example, in a possible design, the A first bit positions are determined based on the K first bit positions and the K second bit positions.

Based on the first possible example and the second possible example, in a possible design, the processing module 1302 may be further configured to determine K third bit positions based on the K first bit positions, where a number of a third bit position corresponding to a first bit position numbered i is $i+N_2-N_1$, and $0 \le i \le N_1-1$; and the processing module 1302 may be further configured to determine the A first bit positions based on A third bit positions, where a number of a first bit position corresponding to a third bit position numbered j is $j-(N_2-N_1)$, $N_2-N_1 \le j \le N_2-1$, and the A third bit positions are bit positions that are in the K third bit positions and whose numbers are different from those of the K second bit positions.

Based on the first possible example and the second possible example, in a possible design, the A first bit positions are the last A bit positions sorted in descending order of reliability in the K first bit positions.

Based on the first possible example and the second possible example, in a possible design, the A second bit positions are determined based on the K first bit positions and the K second bit positions.

Based on the first possible example and the second possible example, in a possible design, the processing module 1302 may be further configured to determine K third bit positions based on the K first bit positions, where a number of a third bit position corresponding to a first bit position numbered i is $i+N_2-N_1$, and $0 \le i \le N_1-1$; and the processing module 1302 may be further configured to determine the A second bit positions based on the K third bit positions, where the A second bit positions are bit positions that are in the K second bit positions and whose numbers are different from those of the K third bit positions.

Based on the first possible example and the second possible example, in a possible design, the A second bit positions are A bit positions whose numbers are less than $N_2-N_1$ in the K second bit positions.

Based on the first possible example and the second possible example, in a possible design, the processing module 1302 may be further configured to: divide the A first bit positions into the X groups of first bit positions based on reliability, where reliability of an $(x+1)^{th}$ group of first bit positions is higher than reliability of the $x^{th}$ group of first bit positions.

Based on the first possible example and the second possible example, in a possible design, the processing module 1302 may be further configured to: perform sub-block interleaving on the first sequence based on a third interleaving pattern, and divide bit positions of an interleaved first sequence into the X groups of bit positions, where the $x^{th}$ group of bit positions includes Yx sub-blocks, and Yx is a positive integer.

Based on the first possible example and the second possible example, in a possible design, the third interleaving pattern is any one of the following sub-block interleaving patterns: [0 1 2 4 3 5 6 7 8 16 9 17 10 18 11 19 12 20 13 21 14 22 15 23 24 25 26 28 27 29 30 31 ], or [0 4 8 12 15 9 13 2 6 10 14 3 7 11 15 16 20 24 28 17 21 25 29 18 22 26 30 19 23 27 31], or [0 8 16 24 1 9 17 25 2 10 18 26 3 11 19 27 4 12 20 28 5 13 21 29 6 14 22 30 7 15 23 31].

Based on the first possible example and the second possible example, in a possible design, the processing module 1302 may be further configured to: divide the bit positions of the first sequence into the X groups of bit positions based on preset configuration information; or divide the bit positions of the first sequence into the X groups of bit positions based on a retransmission resource.

Based on the first possible example and the second possible example, in a possible design, a length of at least one group of bit positions in the X groups of bit positions is an integer power of 2.

Based on the first possible example and the second possible example, in a possible design, a length of a first group of bit positions in the X groups of bit positions is an integer power of 2.

Based on the first possible example and the second possible example, in a possible design, a length from the first group of bit positions to an $x'^{th}$ group of bit positions in the X groups of bit positions is an integer power of 2, where $2 \le x' \le X$.

Based on the first possible example and the second possible example, in a possible design, X is equal to 2, the first group of bit positions in the X groups of bit positions includes $(N_2-N_1)/8$ bit positions of the first sequence, and a second group of bit positions includes $7(N_2-N_1)/8$ bit positions of the first sequence.

Based on the first possible example and the second possible example, in a possible design, X is equal to 3, the first group of bit positions in the X groups of bit positions includes $(N_2-N_1)/8$ bit positions of the first sequence, a second group of bit positions includes $(N_2-N_1)/8$ bit positions of the first sequence, and a third group of bit positions includes $3(N_2-N_1)/4$ bit positions of the first sequence.

Based on the first possible example and the second possible example, in a possible design, X is equal to 4, the first group of bit positions in the X groups of bit positions includes $(N_2-N_1)/8$ bit positions of the first sequence, a second group of bit positions includes $(N_2-N_1)/8$ bit positions of the first sequence, a third group of bit positions includes $(N_2-N_1)/4$ bit positions of the first sequence, and a fourth group of bit positions includes $(N_2-N_1)/2$ bit positions of the first sequence.

Based on the first possible example and the second possible example, in a possible design, X is equal to 2, the first group of bit positions in the X groups of bit positions includes $(N_2-N_1)/4$ bit positions of the first sequence, and a second group of bit positions includes $3(N_2-N_1)/4$ bit positions of the first sequence.

In a third possible example, the processing module 1302 is configured to: divide bit positions of a seventh sequence having a length of N into X groups of bit positions, and divide A information bits in an information bit sequence having a length of K into X groups of information bits, where a quantity of information bit positions included in an $x^{th}$ group of bit positions is equal to a quantity of information bits included in an $x^{th}$ group of information bits, x=1, 2, ..., X, and X≥2; the processing module 1302 is further configured to: map, in an interleaving manner based on an interleaving pattern, the $x^{th}$ group of information bits to the information bit positions in the $x^{th}$ group of bit positions of the seventh sequence, to obtain an eighth sequence, and perform polar coding on the eighth sequence to obtain an encoded bit sequence; and the transceiver module 1301 is configured to send one or more bits in the encoded bit sequence to a receiver device.

In a possible design, the processing module 1302 may be further configured to perform sub-block interleaving on the seventh sequence, and divide bit positions of an interleaved seventh sequence into the X groups of bit positions.

In a possible design, the interleaving pattern is one or more of the following: a random interleaving pattern, a triangular interleaving pattern, a row-column interleaving pattern, or a reverse-order interleaving pattern.

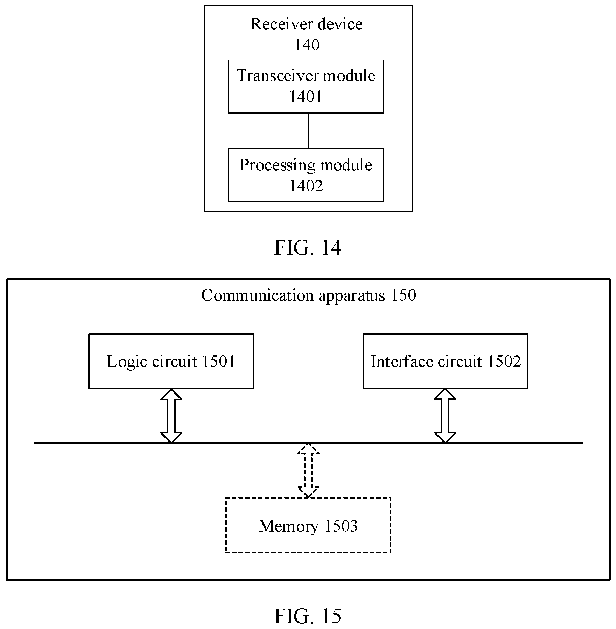

FIG. 14 shows a receiver device 140. The receiver device 140 may perform actions performed by the receiver device in the methods shown in FIG. 8 to FIG. 12. All related content of steps in the foregoing method embodiments may be referenced to function descriptions of corresponding functional modules. For technical effects that can be achieved, refer to the foregoing method embodiments. Details are not described herein again.

The receiver device 140 may include a transceiver module 1401 and a processing module 1402. For example, the receiver device 140 may be a communication device, or may be a chip used in the communication device, or another combined device or component that has a function of the foregoing receiver device. When the receiver device 140 is a communication device, the transceiver module 1401 may be a transceiver. The transceiver may include an antenna, a radio frequency circuit, and the like. The processing module 1402 may be a processor (or a processing circuit), for example, a baseband processor. The baseband processor may include one or more CPUs. When the receiver device 140 is a component that has a function of the foregoing receiver device, the transceiver module 1401 may be a radio frequency unit, and the processing module 1402 may be a processor (or a processing circuit), for example, a baseband processor. When the receiver device 140 is a chip system, the transceiver module 1401 may be an input/output interface of a chip (for example, a baseband chip); and the processing module 1402 may be a processor (or a processing circuit) of the chip system, and may include one or more central processing units. It should be understood that the transceiver module 1401 in this embodiment of this application may be implemented by a transceiver or a transceiver-related circuit component, and the processing module 1402 may be implemented by a processor or a processor-related circuit component (or referred to as a processing circuit).

For example, the transceiver module 1401 may be configured to perform all sending and receiving operations performed by the receiver device in embodiments shown in FIG. 8 to FIG. 12, and/or configured to support another process of the technology described in this specification. The processing module 1402 may be configured to perform all operations other than sending and receiving operations performed by the receiver device in embodiments shown in FIG. 8 to FIG. 12, and/or configured to support another process of the technology described in this specification.

In a first possible example, the transceiver module 1401 is configured to: receive a symbol sequence from a transmitter device, where an information bit sequence corresponding to the symbol sequence has a length of K; the processing module 1402 is configured to: determine K first bit positions based on a reliability sequence having a length of $N_1$, and determine K second bit positions based on a reliability sequence having a length of $N_2$, where $K \leq N_1 < N_2$; the processing module 1402 is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, X≥2, and x=1, 2, ..., X; and the processing module 1402 is further configured to decode the symbol sequence based on second bit positions in the X groups of bit positions and the X groups of first bit positions.

In a second possible example, the transceiver module 1401 is configured to: receive a symbol sequence from a transmitter device, where an information bit sequence corresponding to the symbol sequence has a length of K; the processing module 1402 is configured to: determine K first bit positions based on a reliability sequence having a length of $N_1$, and determine K second bit positions based on a reliability sequence having a length of $N_2$, where $K \leq N_1 < N_2$; the processing module 1402 is further configured to: divide bit positions of a first sequence having a length of $(N_2-N_1)$ into X groups of bit positions, and divide A first bit positions in the K first bit positions into X groups of first bit positions, where the X groups of bit positions include A second bit positions in the K second bit positions, and a quantity of first bit positions included in an $x^{th}$ group of first bit positions is the same as a quantity of second bit positions included in an $x^{th}$ group of bit positions, $X \geq 2$, and $x=1, 2, ..., X$; and the processing module 1402 is further configured to: decode the symbol sequence based on second bit positions in the X groups of bit positions and X groups of third bit positions, where an $x^{th}$ group of third bit positions corresponds to the $x^{th}$ group of first bit positions, $X \geq 2$, and $x=1, 2, ..., X$.

Based on the first possible example and the second possible example, in a possible design, the A first bit positions are determined based on the K first bit positions and the K second bit positions.

Based on the first possible example and the second possible example, in a possible design, the processing module 1402 may be further configured to determine K third bit positions based on the K first bit positions, where a number of a third bit position corresponding to a first bit position numbered i is $i+N_2-N_1$, and $0 \leq i \leq N_1-1$; and the processing module 1402 may be further configured to determine the A first bit positions based on A third bit positions, where a number of a first bit position corresponding to a third bit position numbered j is $j-(N_2-N_1)$, $N_2-N_1 \leq j \leq N_2-1$, and the A third bit positions are bit positions that are in the K third bit positions and whose numbers are different from those of the K second bit positions.

Based on the first possible example and the second possible example, in a possible design, the A first bit positions are the last A bit positions sorted in descending order of reliability in the K first bit positions.

Based on the first possible example and the second possible example, in a possible design, the A second bit positions are determined based on the K first bit positions and the K second bit positions.

Based on the first possible example and the second possible example, in a possible design, the processing module 1402 may be further configured to determine K third bit positions based on the K first bit positions, where a number of a third bit position corresponding to a first bit position numbered i is $i+N_2-N_1$, and $0 \leq i \leq N_1-1$; and the processing module 1402 may be further configured to determine the A second bit positions based on the K third bit positions, where the A second bit positions are bit positions that are in the K second bit positions and whose numbers are different from those of the K third bit positions.

Based on the first possible example and the second possible example, in a possible design, the A second bit positions are A bit positions whose numbers are less than $N_2-N_1$ in the K second bit positions.

Based on the first possible example and the second possible example, in a possible design, the processing module 1402 may be further configured to: divide the A first bit positions into the X groups of first bit positions based on reliability, where reliability of an $(x+1)^{th}$ group of first bit positions is higher than reliability of the $x^{th}$ group of first bit positions.

Based on the first possible example and the second possible example, in a possible design, the processing module 1402 may be further configured to: perform sub-block interleaving on the first sequence based on a third interleaving pattern, and divide bit positions of an interleaved first sequence into the X groups of bit positions, where the $x^{th}$ group of bit positions includes Yx sub-blocks, and Yx is a positive integer.

Based on the first possible example and the second possible example, in a possible design, the third interleaving pattern is any one of the following sub-block interleaving patterns: [0 1 2 4 3 5 6 7 8 16 9 17 10 18 11 19 12 20 13 21 14 22 15 23 24 25 26 28 27 29 30 31], or [0 4 8 12 1 5 9 13 2 6 10 14 3 7 11 15 16 20 24 28 17 21 25 29 18 22 26 30 19 23 27 31], or [0 8 16 24 1 9 17 25 2 10 18 26 3 11 19 27 4 12 20 28 5 13 21 29 6 14 22 30 7 15 23 31].

Based on the first possible example and the second possible example, in a possible design, the processing module 1402 may be further configured to: divide the bit positions of the first sequence into the X groups of bit positions based on preset configuration information; or divide the bit positions of the first sequence into the X groups of bit positions based on a retransmission resource.

Based on the first possible example and the second possible example, in a possible design, a length of at least one group of bit positions in the X groups of bit positions is an integer power of 2.

Based on the first possible example and the second possible example, in a possible design, a length of a first group of bit positions in the X groups of bit positions is an integer power of 2.

Based on the first possible example and the second possible example, in a possible design, a length from the first group of bit positions to an $x'^{th}$ group of bit positions in the X groups of bit positions is an integer power of 2, where $2 \leq x' \leq X$.

Based on the first possible example and the second possible example, in a possible design, X is equal to 2, the first group of bit positions in the X groups of bit positions includes $(N_2-N_1)/8$ bit positions of the first sequence, and a second group of bit positions includes $7(N_2-N_1)/8$ bit positions of the first sequence.

Based on the first possible example and the second possible example, in a possible design, X is equal to 3, the first group of bit positions in the X groups of bit positions includes $(N_2-N_1)/8$ bit positions of the first sequence, a second group of bit positions includes $(N_2-N_1)/8$ bit positions of the first sequence, and a third group of bit positions includes $3(N_2-N_1)/4$ bit positions of the first sequence.

Based on the first possible example and the second possible example, in a possible design, X is equal to 4, the first group of bit positions in the X groups of bit positions includes $(N_2-N_1)/8$ bit positions of the first sequence, a second group of bit positions includes $(N_2-N_1)/8$ bit positions of the first sequence, a third group of bit positions includes $(N_2-N_1)/4$ bit positions of the first sequence, and a fourth group of bit positions includes $(N_2-N_1)/2$ bit positions of the first sequence.

Based on the first possible example and the second possible example, in a possible design, X is equal to 2, the first group of bit positions in the X groups of bit positions includes $(N_2-N_1)/4$ bit positions of the first sequence, and a second group of bit positions includes $3(N_2-N_1)/4$ bit positions of the first sequence.

In a third possible example, the transceiver module 1401 is further configured to: receive a symbol sequence from a transmitter device; the processing module is configured to: divide bit positions of a seventh sequence having a length of N into X groups of bit positions, where $X\geq2$; and the processing module 1402 is further configured to: decode the symbol sequence based on information bit positions in the X groups of bit positions.

In a possible design, the processing module 1402 may be further configured to perform sub-block interleaving on the seventh sequence, and divide bit positions of an interleaved seventh sequence into the X groups of bit positions.

In a possible design, the interleaving pattern is one or more of the following: a random interleaving pattern, a triangular interleaving pattern, a row-column interleaving pattern, or a reverse-order interleaving pattern.

In another implementation, the transceiver module 1301 in FIG. 13 may be replaced with a transceiver, where a function of the transceiver module 1301 may be integrated into the transceiver; and the processing module 1302 may be replaced with a processor, where a function of the processing module 1302 may be integrated into the processor. Further, the transmitter device 130 shown in FIG. 13 may further include a memory. Alternatively, the transceiver module 1401 in FIG. 14 may be replaced with a transceiver, where a function of the transceiver module 1401 may be integrated into the transceiver; and the processing module 1402 may be replaced with a processor, where a function of the processing module 1402 may be integrated into the processor. Further, the receiver device 140 shown in FIG. 14 may further include a memory.

Alternatively, when the processing module 1302 is replaced with a processor, and the transceiver module 1301 is replaced with a transceiver, the transmitter device 130 in this embodiment of this application may alternatively be a communication apparatus 150 shown in FIG. 15. Alternatively, when the processing module 1402 is replaced with a processor, and the transceiver module 1401 is replaced with a transceiver, the receiver device 140 in this embodiment of this application may alternatively be a communication apparatus 150 shown in FIG. 15.

The processor may be a logic circuit 1501, and the transceiver may be an interface circuit 1502. Further, the communication apparatus 150 shown in FIG. 15 may further include a memory 1503.

An embodiment of this application further provides a computer program product. When the computer program product is executed by a computer, a function of any one of the foregoing method embodiments may be implemented.

An embodiment of this application further provides a computer program. When the computer program is executed by a computer, a function of any one of the foregoing method embodiments may be implemented.

Embodiments of this application further provide a computer-readable storage medium. All or some of procedures in the foregoing method embodiments may be implemented by a computer program instructing related hardware. The program may be stored in the foregoing computer-readable storage medium. When the program is executed, the procedures in the foregoing method embodiments may be performed. The computer-readable storage medium may be an internal storage unit in the terminal in any one of the foregoing embodiments (including a data transmit end and/or a data receive end), for example, a hard disk or an internal memory of the terminal. The foregoing computer-readable storage medium may also be an external storage device of the foregoing terminal, for example, a plug-in hard disk, a smart memory card (smart media card, SMC), a secure digital (secure digital, SD) card, and a flash card (flash card) that are configured on the foregoing terminal. Further, the computer-readable storage medium may further include both an internal storage unit and an external storage device of the foregoing terminal. The computer-readable storage medium is configured to store the computer program and other programs and data required by the foregoing terminal. The computer-readable storage medium may be further configured to temporarily store data that has been output or is to be output.

It should be noted that, in the specification, claims, and accompanying drawings of this application, the terms "first", "second", and the like are intended to distinguish between different objects but do not indicate a particular order. "First" and "second" are merely intended for description, and shall not be understood as an indication or implication of relative importance or an implicit indication of a quantity of indicated technical features. Therefore, a feature limited by "first" or "second" may explicitly or implicitly include one or more features. In the description of embodiments, unless otherwise specified, "a plurality of" means two or more.

In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

It should be understood that in this application, "at least one (item)" means one or more. "A plurality of " refers to two or more than two. "At least two (items)" means two, three, or more than three. "And/or" is used to describe an association relationship between associated objects, and indicates that three relationships may exist. For example, "A and/or B" may represent three cases: Only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c,

## EP 4 779 908 A1

b and c, or a, b, and c, where a, b, and c may be singular or plural. Both "when ..." and "if" mean that corresponding processing is performed in an objective case, are not intended to limit time, do not require a determining action during implementation, and do not mean that there is another limitation.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In this application, "sending information to ... (a terminal device)" may be understood as that a destination of the information is the terminal device, and may include directly or indirectly sending the information to the terminal device; and "Receiving information from ... (a terminal device)" may be understood as that a source of the information is the terminal device, and may include directly or indirectly receiving the information from the terminal device. Information may undergo necessary processing, for example, a format change, between a source end for sending the information and a destination end. However, the destination end may understand valid information from the source end.

The foregoing descriptions about implementations allow a person skilled in the art to understand that, for the purpose of convenient and brief description, division of the foregoing functional modules is taken as an example for illustration. In actual application, the foregoing functions can be allocated to different functional modules and implemented according to a requirement, that is, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such understanding, the technical solutions of this application essentially or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The foregoing storage medium includes any medium that can store program code, such as a USB flash drive, a removable hard disk, a ROM, a RAM, a magnetic disk, or an optical disc.

## Claims

1. A communication method, comprising:

   determining K first bit positions based on a reliability sequence having a length of $N_1$, and determining K second bit positions based on a reliability sequence having a length of $N_2$, wherein K is less than or equal to $N_1$, and $N_1$ is less than $N_2$;
   
   dividing bit positions of a first sequence having a length of $(N_2-N_1)$ into X groups of bit positions, and dividing A first bit positions in the K first bit positions into X groups of first bit positions, wherein the X groups of bit positions comprise A second bit positions in the K second bit positions, a quantity of first bit positions comprised in an $x^{th}$ group of first bit positions is the same as a quantity of second bit positions comprised in an $x^{th}$ group of bit positions, X is greater than or equal to 2, and x=1, 2, ..., X;
   
   mapping, based on an information bit sequence having a length of K, information bits corresponding to the $x^{th}$ group of first bit positions to the second bit positions in the $x^{th}$ group of bit positions of the first sequence, to obtain a second sequence;

performing polar coding on the second sequence to obtain an encoded bit sequence; and
sending one or more bits in the encoded bit sequence to a receiver device.

2. The method according to claim 1, wherein the mapping the information bits corresponding to the $x^{th}$ group of first bit positions to the second bit positions in the $x^{th}$ group of bit positions of the first sequence comprises:
mapping, in an interleaving manner based on a first interleaving pattern, the information bits corresponding to the $x^{th}$ group of first bit positions to the second bit positions in the $x^{th}$ group of bit positions.

3. The method according to claim 2, wherein the mapping, in the interleaving manner based on the first interleaving pattern, the information bits corresponding to the $x^{th}$ group of first bit positions to the second bit positions in the $x^{th}$ group of bit positions comprises:
mapping, in the interleaving manner based on the first interleaving pattern, information bits corresponding to first bit positions sorted in ascending order of numbers in the $x^{th}$ group of first bit positions to second bit positions sorted in descending order of numbers in the $x^{th}$ group of bit positions.

4. The method according to any one of claims 1 to 3, comprising:

   mapping the information bit sequence to the K first bit positions of a third sequence having a length of $N_1$, to obtain a fourth sequence; and
   determining, based on information bits corresponding to the A first bit positions in the K first bit positions, the information bits corresponding to the $x^{th}$ group of first bit positions.

5. The method according to claim 4, wherein the performing polar coding on the second sequence comprises:

   performing exclusive OR processing on the second sequence and the fourth sequence to obtain an XOR-processed sequence; and
   performing polar coding on the XOR-processed sequence, to obtain an encoded bit sequence.

6. The method according to claim 4, wherein the performing polar coding on the second sequence comprises:

   performing polar coding on the second sequence to obtain a first polarization sequence;
   performing polar coding on the fourth sequence to obtain a second polarization sequence; and
   performing exclusive OR processing on the first polarization sequence and the second polarization sequence to obtain an encoded bit sequence.

7. A communication method, comprising:

   receiving a symbol sequence from a transmitter device, wherein an information bit sequence corresponding to the symbol sequence has a length of K;
   determining K first bit positions based on a reliability sequence having a length of $N_1$, and determining K second bit positions based on a reliability sequence having a length of $N_2$, wherein K is less than or equal to $N_1$, and $N_1$ is less than $N_2$;
   dividing bit positions of a first sequence having a length of $(N_2-N_1)$ into X groups of bit positions, and dividing A first bit positions in the K first bit positions into X groups of first bit positions, wherein the X groups of bit positions comprise A second bit positions in the K second bit positions, a quantity of first bit positions comprised in an $x^{th}$ group of first bit positions is the same as a quantity of second bit positions comprised in an $x^{th}$ group of bit positions, X is greater than or equal to 2, and x=1, 2, ..., X; and
   decoding the symbol sequence based on second bit positions in the X groups of bit positions and the X groups of first bit positions.

8. A communication method, comprising:

   determining K first bit positions based on a reliability sequence having a length of $N_1$, and determining K second bit positions based on a reliability sequence having a length of $N_2$, wherein K is less than or equal to $N_1$, and $N_1$ is less than $N_2$;
   dividing bit positions of a first sequence having a length of $(N_2-N_1)$ into X groups of bit positions, and dividing A first bit positions in the K first bit positions into X groups of first bit positions, wherein the X groups of bit positions comprise A second bit positions in the K second bit positions, a quantity of first bit positions comprised in an $x^{th}$

group of first bit positions is the same as a quantity of second bit positions comprised in the $x^{th}$ group of bit positions, X is greater than or equal to 2, and x=1, 2, ..., X;

mapping, based on an information bit sequence having a length of K, information bits corresponding to the $x^{th}$ group of first bit positions to an $x^{th}$ group of third bit positions in a fifth sequence having a length of $N_2$, and mapping copy bits of the information bits corresponding to the $x^{th}$ group of first bit positions to the second bit positions in the $x^{th}$ group of bit positions in the fifth sequence, to obtain a sixth sequence, wherein the $x^{th}$ group of third bit positions corresponds to the $x^{th}$ group of first bit positions;

performing polar coding on the sixth sequence to obtain an encoded bit sequence; and

sending one or more bits in the encoded bit sequence to a receiver device.

9. The method according to claim 8, wherein the mapping the information bits corresponding to the $x^{th}$ group of first bit positions to the $x^{th}$ group of third bit positions in the fifth sequence having a length of $N_2$, and mapping the copy bits of the information bits corresponding to the $x^{th}$ group of first bit positions to the second bit positions in the $x^{th}$ group of bit positions in the fifth sequence comprises:

mapping, in an interleaving manner based on a second interleaving pattern, the information bits corresponding to the $x^{th}$ group of first bit positions to the $x^{th}$ group of third bit positions in the fifth sequence, and mapping, in an interleaving manner, the copy bits of the information bits corresponding to the $x^{th}$ group of first bit positions to the second bit positions in the $x^{th}$ group of bit positions in the fifth sequence.

10. The method according to claim 8 or 9, comprising:

mapping the information bit sequence to the K first bit positions of a third sequence having a length of $N_1$, to obtain a fourth sequence; and

determining, based on information bits corresponding to the A first bit positions in the K first bit positions, the information bits corresponding to the $x^{th}$ group of first bit positions.

11. The method according to any one of claims 8 to 10, wherein the method further comprises:

mapping K-A information bits other than A information bits corresponding to the X groups of first bit positions in the information bit sequence to K-A second bit positions other than the A second bit positions in the K second bit positions of the fifth sequence.

12. A communication method, comprising:

receiving a symbol sequence from a transmitter device, wherein an information bit sequence corresponding to the symbol sequence has a length of K;

determining K first bit positions based on a reliability sequence having a length of $N_1$, and determining K second bit positions based on a reliability sequence having a length of $N_2$, wherein K is less than or equal to $N_1$, and $N_1$ is less than $N_2$;

dividing bit positions of a first sequence having a length of $(N_2-N_1)$ into X groups of bit positions, and dividing A first bit positions in the K first bit positions into X groups of first bit positions, wherein the X groups of bit positions comprise A second bit positions in the K second bit positions, a quantity of first bit positions comprised in an $x^{th}$ group of first bit positions is the same as a quantity of second bit positions comprised in the $x^{th}$ group of bit positions, X is greater than or equal to 2, and x=1, 2, ..., X; and

decoding the symbol sequence based on second bit positions in the X groups of bit positions and X groups of third bit positions, wherein an $x^{th}$ group of third bit positions corresponds to the $x^{th}$ group of first bit positions.

13. The method according to any one of claims 1 to 12, wherein the A first bit positions are determined based on the K first bit positions and the K second bit positions.

14. The method according to claim 13, comprising:

determining K third bit positions based on the K first bit positions, wherein a number of a third bit position corresponding to a first bit position numbered i is $i+N_2-N_1$, i is greater than or equal to 0, and i is less than or equal to $N_1-1$; and

determining the A first bit positions based on A third bit positions, wherein a number of a first bit position corresponding to a third bit position numbered j is $j-(N_2-N_1)$, j is greater than or equal to $N_2-N_1$, j is less than or equal to $N_2-1$, and the A third bit positions are bit positions that are in the K third bit positions and whose numbers are different from those of the K second bit positions.

**15.** The method according to any one of claims 1 to 12, wherein
the A first bit positions are the last A bit positions sorted in descending order of reliability in the K first bit positions.

**16.** The method according to any one of claims 1 to 15, wherein
the A second bit positions are determined based on the K first bit positions and the K second bit positions.

**17.** The method according to claim 16, comprising:

determining K third bit positions based on the K first bit positions, wherein a number of a third bit position corresponding to a first bit position numbered i is $i+N_2-N_1$, i is greater than or equal to 0, and i is less than or equal to $N_1-1$; and
determining the A second bit positions based on the K third bit positions, wherein the A second bit positions are bit positions that are in the K second bit positions and whose numbers are different from those of the K third bit positions.

**18.** The method according to any one of claims 1 to 15, wherein
the A second bit positions are A bit positions whose numbers are less than $N_2-N_1$ in the K second bit positions.

**19.** The method according to any one of claims 1 to 17, wherein the dividing the A first bit positions in the K first bit positions into the X groups of first bit positions comprises:
dividing the A first bit positions into the X groups of first bit positions based on reliability, wherein reliability of an $(x+1)^{th}$ group of first bit positions is higher than reliability of the $x^{th}$ group of first bit positions.

**20.** The method according to any one of claims 1 to 19, wherein the dividing the bit positions of the first sequence having a length of $(N_2-N_1)$ into the X groups of bit positions comprises:
performing sub-block interleaving on the first sequence based on a third interleaving pattern, and dividing bit positions of an interleaved first sequence into the X groups of bit positions, wherein the $x^{th}$ group of bit positions comprises Yx sub-blocks, and Yx is a positive integer.

**21.** The method according to claim 20, wherein the third interleaving pattern is any one of the following sub-block interleaving patterns:

[0 1 2 4 3 5 6 7 8 16 9 17 10 18 11 19 12 20 13 21 14 22 15 23 24 25 26 28 27 29 30 31]; or
[0 4 8 12 1 5 9 13 2 6 10 14 3 7 11 15 16 20 24 28 17 21 25 29 18 22 26 30 19 23 27 31]; or
[0 8 16 24 1 9 17 25 2 10 18 26 3 11 19 27 4 12 20 28 5 13 21 29 6 14 22 30 7 15 23 31].

**22.** The method according to any one of claims 1 to 21, wherein the dividing the bit positions of the first sequence having a length of $(N_2-N_1)$ into the X groups of bit positions comprises:

dividing the bit positions of the first sequence into the X groups of bit positions based on preset configuration information; or
dividing the bit positions of the first sequence into the X groups of bit positions based on a retransmission resource.

**23.** The method according to any one of claims 1 to 22, wherein
a length of at least one group of bit positions in the X groups of bit positions is an integer power of 2.

**24.** The method according to any one of claims 1 to 23, wherein
a length of a first group of bit positions in the X groups of bit positions is an integer power of 2.

**25.** The method according to claim 24, wherein
a length from the first group of bit positions to an $x'^{th}$ group of bit positions in the X groups of bit positions is an integer power of 2, x' is greater than or equal to 2, and x' is less than or equal to X.

**26.** The method according to any one of claims 1 to 25, wherein

X is equal to 2, the first group of bit positions in the X groups of bit positions comprises $(N_2-N_1)/8$ bit positions of the first sequence, and a second group of bit positions comprises $7(N_2-N_1)/8$ bit positions of the first sequence; or

X is equal to 3, the first group of bit positions in the X groups of bit positions comprises $(N_2-N_1)/8$ bit positions of the first sequence, a second group of bit positions comprises $(N_2-N_1)/8$ bit positions of the first sequence, and a third group of bit positions comprises $3(N_2-N_1)/4$ bit positions of the first sequence; or

X is equal to 4, the first group of bit positions in the X groups of bit positions comprises $(N_2-N_1)/8$ bit positions of the first sequence, a second group of bit positions comprises $(N_2-N_1)/8$ bit positions of the first sequence, a third group of bit positions comprises $(N_2-N_1)/4$ bit positions of the first sequence, and a fourth group of bit positions comprises $(N_2-N_1)/2$ bit positions of the first sequence; or

X is equal to 2, the first group of bit positions in the X groups of bit positions comprises $(N_2-N_1)/4$ bit positions of the first sequence, and a second group of bit positions comprises $3(N_2-N_1)/4$ bit positions of the first sequence.

27. A communication method, comprising:

dividing bit positions of a seventh sequence having a length of N into X groups of bit positions, and dividing A information bits in an information bit sequence having a length of K into X groups of information bits, wherein a quantity of information bit positions comprised in an $x^{th}$ group of bit positions is equal to a quantity of information bits comprised in an $x^{th}$ group of information bits, x=1, 2, ..., X, and X is greater than or equal to 2;
mapping, in an interleaving manner based on an interleaving pattern, the $x^{th}$ group of information bits to the information bit positions in the $x^{th}$ group of bit positions of the seventh sequence, to obtain an eighth sequence;
performing polar coding on the eighth sequence to obtain an encoded bit sequence; and
sending one or more bits in the encoded bit sequence to a receiver device.

28. A communication method, comprising:

receiving a symbol sequence from a transmitter device;
dividing bit positions of a seventh sequence having a length of N into X groups of bit positions, wherein X is greater than or equal to 2; and
decoding the symbol sequence based on information bit positions in the X groups of bit positions.

29. The method according to claim 27 or 28, wherein the dividing the bit positions of the seventh sequence having a length of N into the X groups of bit positions comprises:
performing sub-block interleaving on the seventh sequence, and dividing bit positions of an interleaved seventh sequence into the X groups of bit positions.

30. The method according to any one of claims 27 to 29, wherein
the interleaving pattern is one or more of the following: a random interleaving pattern, a triangular interleaving pattern, a row-column interleaving pattern, or a reverse-order interleaving pattern.

31. A communication apparatus, wherein the communication apparatus comprises a processor; and the processor is configured to run a computer program or instructions, so that the communication method according to any one of claims 1 to 6 and 13 to 26 is performed, or the communication method according to any one of claims 7 and 13 to 26 is performed, or the communication method according to any one of claims 8 to 11 and 13 to 26 is performed, or the communication method according to any one of claims 12 to 26 is performed, or the communication method according to any one of claims 27, 29, and 30 is performed, or the communication method according to any one of claims 28 to 30 is performed.

32. The communication apparatus according to claim 31, wherein
the communication apparatus further comprises a memory, and the memory is configured to store the computer program or the instructions.

33. A communication apparatus, wherein the communication apparatus comprises an interface circuit and a logic circuit; the interface circuit is configured to input and/or output information; and the logic circuit is configured to perform the communication method according to any one of claims 1 to 6 and 13 to 26, or perform the communication method according to any one of claims 7 and 13 to 26, or perform the communication method according to any one of claims 8 to 11 and 13 to 26, or perform the communication method according to any one of claims 12 to 26, or perform the communication method according to any one of claims 27, 29, and 30, or perform the communication method according to any one of claims 28 to 30; and perform processing based on the information and/or generate the information.

34. A computer-readable storage medium, wherein the computer-readable storage medium stores computer instructions or a program, and when the computer instructions or the program is run on a computer, the communication method according to any one of claims 1 to 6 and 13 to 26 is performed, or the communication method according to any one of claims 7 and 13 to 26 is performed, or the communication method according to any one of claims 8 to 11 and 13 to 26 is performed, or the communication method according to any one of claims 12 to 26 is performed, or the communication method according to any one of claims 27, 29, and 30 is performed, or the communication method according to any one of claims 28 to 30 is performed.

35. A computer program product, wherein the computer program product comprises computer instructions; and when some or all of the computer instructions are run on a computer, the communication method according to any one of claims 1 to 6 and 13 to 26 is performed, or the communication method according to any one of claims 7 and 13 to 26 is performed, or the communication method according to any one of claims 8 to 11 and 13 to 26 is performed, or the communication method according to any one of claims 12 to 26 is performed, or the communication method according to any one of claims 27, 29, and 30 is performed, or the communication method according to any one of claims 28 to 30 is performed.

36. A communication system, comprising a communication apparatus configured to perform the communication method according to any one of claims 1 to 6 and 13 to 26 and a communication apparatus configured to perform the communication method according to any one of claims 7 and 13 to 26; or comprising a communication apparatus configured to perform the communication method according to any one of claims 8 to 11 and 13 to 26 and a communication apparatus configured to perform the communication method according to any one of claims 12 to 26; or comprising a communication apparatus configured to perform the communication method according to any one of claims 27, 29, and 30, and a communication apparatus configured to perform the communication method according to any one of claims 28 to 30.

FIG. 1

⊛ Graph 1

⊕ Graph 2

● Graph 3

Retransmission
sequence
(V code)

Initial
transmission
sequence
(U code)

FIG. 2

FIG. 3

FIG. 4

(a) Large quantity of retransmission

(b) Small quantity of retransmission

Retransmission sequence (V code)

Initial transmission sequence (U code)

⊛ Graph 1
⊕ Graph 2
● Graph 3

Network device

Terminal device 1

Terminal device 2

Terminal device 3

FIG. 5

| Transmitter device (source) | → | Source encoding | → | Channel encoding | → | Modulation |

| Receiver device (sink) | ← | Source recovery | ← | Channel decoding | ← | Demodulation |

FIG. 6

700

701 Processor
CPU 0
CPU 1

707 Processor
CPU 0
CPU 1

704 Memory

Communication line 703

702 Transceiver

705 Output device

706 Input device

FIG. 7

Transmitter device | Receiver device

801: Determine K first bit positions based on a reliability sequence having a length of $N_1$

802: Determine K second bit positions based on a reliability sequence having a length of $N_2$

803: Divide bit positions of a first sequence having a length of $(N_2-N_1)$ into X groups of bit positions

804: Divide A first bit positions in the K first bit positions into X groups of first bit positions

805: Map, based on an information bit sequence having a length of K, information bits corresponding to the $x^{th}$ group of first bit positions to the second bit positions in the $x^{th}$ group of bit positions of the first sequence, to obtain a second sequence

806: The transmitter device performs polar coding on the second sequence to obtain an encoded bit sequence

807: Send one or more bits in the encoded bit sequence

807: Receive a symbol sequence

808: Determine K first bit positions based on a reliability sequence having a length of $N_1$, and determine K second bit positions based on a reliability sequence having a length of $N_2$

809: Divide bit positions of a first sequence having a length of $(N_2-N_1)$ into X groups of bit positions, and divide A first bit positions in the K first bit positions into X groups of first bit positions

810: Decode the symbol sequence based on the X groups of first bit positions and second bit positions in the X groups of bit positions

FIG. 8

FIG. 9

Transmitter device

Receiver device

1001: Determine K first bit positions based on a reliability sequence having a length of $N_1$

1002: Determine K second bit positions based on a reliability sequence having a length of $N_2$

1003: Divide bit positions of a first sequence having a length of $(N_2-N_1)$ into X groups of bit positions

1004: Divide A first bit positions in the K first bit positions into X groups of first bit positions

1005: Map, based on an information bit sequence having a length of K, information bits corresponding to the $x^{th}$ group of first bit positions to an $x^{th}$ group of third bit positions in a fifth sequence having a length of $N_2$, and map copy bits of the information bits corresponding to the $x^{th}$ group of first bit positions to the second bit positions in the $x^{th}$ group of bit positions in the fifth sequence, to obtain a sixth sequence

1006: Perform polar coding on the sixth sequence to obtain an encoded bit sequence

1007: Send one or more bits in the encoded bit sequence

1007: Receive a symbol sequence

1008: Determine K first bit positions based on a reliability sequence having a length of $N_1$, and determine K second bit positions based on a reliability sequence having a length of $N_2$

1009: Divide bit positions of a first sequence having a length of $(N_2-N_1)$ into X groups of bit positions, and divide A first bit positions in the K first bit positions into X groups of first bit positions

1010: Decode the symbol sequence based on second bit positions in the X groups of bit positions and X groups of third bit positions

FIG. 10

FIG. 11

```
┌──────────────┐                              ┌──────────────┐
│  Transmitter │                              │   Receiver   │
│    device    │                              │    device    │
└──────────────┘                              └──────────────┘
```

1201: Divide bit positions of a seventh sequence having a length of N into X groups of bit positions, and divide A information bits in an information bit sequence having a length of K into X groups of information bits

1202: Map, in an interleaving manner based on an interleaving pattern, the $x^{th}$ group of information bits to the information bit positions in the $x^{th}$ group of bit positions of the seventh sequence, to obtain an eighth sequence

1203: Perform polar coding on the eighth sequence to obtain an encoded bit sequence

1204: Send one or more bits in the encoded bit sequence

1204: Receive a symbol sequence

1205: Divide bit positions of a seventh sequence having a length of N into X groups of bit positions

1206: Decode the symbol sequence based on information bit positions in the X groups of bit positions

FIG. 12

```
┌─────────────────────────────┐
│    Transmitter device       │
│           130               │
│  ┌───────────────────────┐  │
│  │  Transceiver module    │  │
│  │        1301            │  │
│  └───────────────────────┘  │
│             │               │
│  ┌───────────────────────┐  │
│  │  Processing module     │  │
│  │        1302            │  │
│  └───────────────────────┘  │
└─────────────────────────────┘
```

FIG. 13

Receiver device
140

Transceiver module
1401

Processing module
1402

FIG. 14

Communication apparatus 150

Logic circuit 1501

Interface circuit 1502

Memory 1503

FIG. 15

## INTERNATIONAL SEARCH REPORT

| | International application No. |
|---|---|
| | **PCT/CN2023/120201** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L 1/-

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 比特, 分 2W 组, 复杂, 极化, 极性, 减小, 降低, 解码, 信息比特, 序列, 译码, 映射, polar?; 3GPP, IEEE, WOTXT, EPTXT, USTXT, VEN: sequence?, decrypt+, bit+, decreas+, decod+, group?, reduc+, polar?, map+, bit?, complex+

**C. DOCUMENTS CONSIDERED TO BE RELEVANT**

| Category* | Citation of document, with indication, where appropriate, of the relevant passages | Relevant to claim No. |
|---|---|---|
| X | CN 114679241 A (HUAWEI TECHNOLOGIES CO., LTD.) 28 June 2022 (2022-06-28) description, paragraphs [90]-[126], and figure 3 | 28-36 |
| A | CN 112703687 A (HUAWEI TECHNOLOGIES CO., LTD.) 23 April 2021 (2021-04-23) description, paragraphs [58]-[77], and figure 3 | 1-36 |
| A | CN 115720124 A (HUAWEI TECHNOLOGIES CO., LTD.) 28 February 2023 (2023-02-28) description, paragraphs [127]-[140], and figure 4 | 1-36 |
| A | US 2023119851 A1 (SAMSUNG ELECTRONICS CO., LTD.) 20 April 2023 (2023-04-20) description, paragraphs [28]-[90] | 1-36 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 May 2024** | **15 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/120201**

| Patent document cited in search report | | | Publication date (day/month/year) | Patent family member(s) | | | Publication date (day/month/year) |
|---|---|---|---|---|---|---|---|
| CN | 114679241 | A | 28 June 2022 | WO | 2022135068 | A1 | 30 June 2022 |
| | | | | US | 2023336273 | A1 | 19 October 2023 |
| CN | 112703687 | A | 23 April 2021 | US | 2023022075 | A1 | 26 January 2023 |
| | | | | US | 11705990 | B2 | 18 July 2023 |
| | | | | EP | 4277133 | A2 | 15 November 2023 |
| | | | | EP | 4277133 | A3 | 03 January 2024 |
| | | | | EP | 3843304 | A1 | 30 June 2021 |
| | | | | EP | 3843304 | A4 | 20 October 2021 |
| | | | | EP | 3843304 | C0 | 05 July 2023 |
| | | | | WO | 2020063315 | A1 | 02 April 2020 |
| | | | | US | 2021211231 | A1 | 08 July 2021 |
| | | | | US | 11496245 | B2 | 08 November 2022 |
| | | | | CN | 110971337 | A | 07 April 2020 |
| | | | | CN | 110971337 | B | 23 February 2021 |
| | | | | CN | 112703687 | B | 22 July 2022 |
| | | | | EP | 3843304 | B1 | 05 July 2023 |
| CN | 115720124 | A | 28 February 2023 | WO | 2023024987 | A1 | 02 March 2023 |
| US | 2023119851 | A1 | 20 April 2023 | WO | 2021261979 | A1 | 30 December 2021 |
| | | | | KR | 20220000707 | A | 04 January 2022 |
| | | | | EP | 4175186 | A1 | 03 May 2023 |
| | | | | EP | 4175186 | A4 | 07 February 2024 |

Form PCT/ISA/210 (patent family annex) (July 2022)